# EUROPEAN PATENT APPLICATION

(11) **EP 4 340 019 A1**
(43) Date of publication of application: **20.03.2024**
(21) Application number: 23176274.1
(22) Date of filing: 31.05.2023
(51) Int. Cl.: H01L 23/48, H01L 23/522, H01L 23/58

(54) **INTEGRATED CIRCUIT**

(30) Priority: 14.09.2022 KR 20220115797
(71) Applicant: Samsung Electronics Co., Ltd., Suwon-si, Gyeonggi-do 16677 (KR)
(72) Inventor: KIM, Jeewoong, 16677 Suwon-si (KR); KIM, Hojun, 16677 Suwon-si (KR); YAMAGUCHI, Taiko, 16677 Suwon-si (KR)
(74) Representative: Marks & Clerk LLP

(57) **Abstract**

An integrated circuit including an inductive element according to some embodiments is provided. The inductive element includes a first through electrode extending in a first direction that is perpendicular to a substrate (e.g., an upper surface of the substrate), an upper metallization pattern connected to the first through electrode and extending in a second direction that is perpendicular to the first direction, and a lower metallization pattern connected to the first through electrode and extending in the second direction, wherein the upper metallization pattern and the lower metallization pattern are spaced apart from each other with the first through electrode therebetween.

## Description

### BACKGROUND

The inventive concept relates to an integrated circuit.

Logic chips collectively refer to semiconductor devices that perform logic operations. Examples of a logic chip include a display driver integrated (DDI) circuit, an application processor (AP), a graphics processing unit (GPU), and the like. Various research has been conducted to reduce the area occupied by standard cells of a logic chip.

Recently, as the number of tracks decreases in ultra-fine processes applied to products of 3-nanometer generation and beyond, metal routing becomes an issue.

In particular, research is being conducted on designs using buried power rail (BPR) to reduce/prevent reduction in the width of metal lines and resultant voltage drops in ultra-fine processes and to provide an improved power grid.

### SUMMARY

Embodiments of the inventive concept may provide a semiconductor device having an improved degree of integration.

According to an aspect of the inventive concept, there is provided an integrated circuit including a substrate including an active region on which a plurality of transistors constituting a logic circuit are disposed, an inductive element disposed adjacent to the active region and extending along an edge of the active region, and first and second guard rings configured to shield the active region from magnetic flux generated from the inductive element. The inductive element includes a first through electrode extending in a first direction that is perpendicular to the substrate (e.g., an upper surface of the substrate), an upper metallization pattern connected to the first through electrode and extending in a second direction that is perpendicular to the first direction, and a lower metallization pattern connected to the first through electrode and extending in the second direction, wherein the upper metallization pattern and the lower metallization pattern are spaced apart from each other with the first through electrode therebetween.

The inductive element may be considered to be an integrated inductive element.

The integrated circuit may comprises a plurality of inductive elements that may be electrically connected in series, such that a winding axis of the series connective inductive elements is substantially perpendicular to the first and second directions.

The first through electrode, and optionally a second through electrode, may extend in a direction parallel to the winding axis. The first and second through electrodes may overlap in a direction parallel to the winding axis.

The integrated circuit may comprises a plurality of input/output wires electrically coupled between said logic circuit and one or more of the inductive elements.

The first and second through electrodes may be spaced along a direction parallel to the winding axis.

The first and second through electrodes may be located between the first and second guard rings so that shielding of the active region from magnetic flux generated from the inductive element is effected.

The term "ring" used here in the context of the guard ring is not intended to limit to any particular shape, e.g. circular. Rather, the term encompasses any suitable shape or configuration including, but not limited to, a linear shape.

According to another aspect of the inventive concept, there is provided an integrated circuit including a first guard ring, a second guard ring spaced apart from the first guard ring, and an inductive element between the first guard ring and the second guard ring. The inductive element includes a first through electrode in (e.g., extending through) a substrate, a first upper metallization pattern connected to the first through electrode and disposed on an upper surface of the substrate, a first lower metallization pattern connected to the first through electrode and disposed on a lower surface of the substrate opposite to the upper surface of the substrate, and a second through electrode connected to the first lower metallization pattern, penetrating the substrate, and spaced apart from the first through electrode, wherein the first upper metallization pattern, the first through electrode, the first lower metallization pattern, and the second through electrode constitute a wound structure having a winding axis extending in a first direction that is parallel to the upper surface of the substrate.

According to another aspect of the inventive concept, there is provided an integrated circuit including an inductive element extending along an edge of an active region including a plurality of transistors, a first guard ring between the active region and the inductive element, and a second guard ring spaced apart from the first guard ring with the inductive element therebetween. A winding axis of the inductive element extends in a first direction that is parallel to an upper surface of a substrate, and the inductive element includes a plurality of through electrodes that extend in a second direction perpendicular to the upper surface of the substrate and are in (e.g., extending through) the substrate.

According to another aspect of the inventive concept, there is provided an integrated circuit including a substrate on which an active region is defined, an inductive element extending in a first direction that is parallel to an edge of the active region, and a first guard ring between the inductive element and the active region. The inductive element includes a first portion and a second portion alternately and repeatedly arranged or disposed in the first direction, wherein the first portion has a first winding structure extending perpendicular to the first direction, and the second portion includes a second winding structure that extends perpendicular to the first direction and is different from the first winding structure.

According to another aspect of the inventive concept, there is provided an integrated circuit including a substrate including an active region on which a plurality of transistors constituting a logic circuit are disposed, an inductive element disposed adjacent to the active region, having a winding axis parallel to the upper surface of the substrate, and including a through electrode in (e.g., extending through) the substrate, a first guard ring disposed between the inductive element and the active region and configured to shield the active region from magnetic flux generated from the inductive element, and a plurality of input/output wires that are connected to the inductive element, are parallel to the upper surface of the substrate, and extend to the active region. The plurality of transistors are formed on an upper surface of the substrate, and the first guard ring includes a guard ring through electrode in (e.g., extending through) the substrate.

At least some of the above and other features of the invention are set out in the claims.

### BRIEF DESCRIPTION OF THE DRAWINGS

Embodiments of the inventive concept will be more clearly understood from the following detailed description taken in conjunction with the accompanying drawings in which:
FIG. 1A is a plan view illustrating an integrated circuit according to some example embodiments;
FIG. 1B is a plan view of a portion AA of FIG. 1A;
FIG. 2A is a cross-sectional view taken along the cutting line 1A-1A' in FIG. 1A;
FIG. 2B is a cross-sectional view taken along the cutting line 1B-1B' in FIG. 1B;
FIG. 2C is a cross-sectional view taken along the cutting line 1C-1C' in FIG. 1B;
FIG. 2D is a cross-sectional view taken along the cutting line 1D-1D' in FIG. 1B;
FIG. 3 is a plan view illustrating an integrated circuit according to some other embodiments;
FIG. 4A to 4D are diagrams illustrating portions of an inductive element according to some other embodiments;
FIG. 5A is a diagram for explaining an inductive element according to some other embodiments;
FIG. 5B is a cross-sectional view taken along the cutting line 5A-5A' in FIG. 5A;
FIG. 5C is a cross-sectional view taken along the cutting line 5B-5B' in FIG. 5A;
FIG. 6A is a diagram for explaining an inductive element according to some other embodiments;
FIG. 6B is a cross-sectional view taken along the cutting line 6A-6A' in FIG. 6A;
FIG. 7A is a diagram for explaining an inductive element according to some other embodiments;
FIG. 7B is a cross-sectional view taken along the cutting line 7A-7A' in FIG. 7A;
FIG. 8A is a diagram for explaining an inductive element according to some other embodiments;
FIG. 8B is a cross-sectional view taken along the cutting line 8A-8A' in FIG. 8A;
FIG. 9A is a diagram for explaining an inductive element according to some other embodiments;
FIG. 9B is a cross-sectional view taken along the cutting line 9A-9A' in FIG. 9A;
FIG. 10A is a diagram for explaining an inductive element according to some other embodiments;
FIG. 10B is a cross-sectional view taken along the cutting line 10A-10A' in FIG. 10A;
FIG. 10C is a cross-sectional view taken along the cutting line 10B-10B' in FIG. 10A;
FIG. 10D is a cross-sectional view taken along the cutting line 10C-10C' in FIG. 10A;
FIG. 11A is a diagram for explaining an inductive element according to some other embodiments;
FIG. 11B is a cross-sectional view taken along the cutting line 11A-11A' in FIG. 11A;
FIG. 12 is a diagram for explaining an inductive element according to some other embodiments;
FIG. 13 is a diagram for explaining an inductive element according to some other embodiments;
FIG. 14A is a diagram for explaining a first guard ring and a plurality of input/output wires according to some other embodiments;
FIG. 14B is a cross-sectional view taken along the cutting line 14A-14A' in FIG. 14A;
FIG. 14C is a cross-sectional view taken along the cutting line 14B-14B' in FIG. 14B;
FIG. 15A is a diagram for explaining a first guard ring and a plurality of input/output wires according to some other embodiments;
FIG. 15B is a cross-sectional view taken along the cutting line 15A-15A' in FIG. 15A; and
FIG. 15C is a cross-sectional view taken along the cutting line 15B-15B' in FIG. 15A.

### DETAILED DESCRIPTION OF THE EMBODIMENTS

Hereinafter, example embodiments of the present invention will be described in detail with reference to the accompanying drawings. The same reference numerals are used for the same components in the drawings, and descriptions already given thereto are omitted.

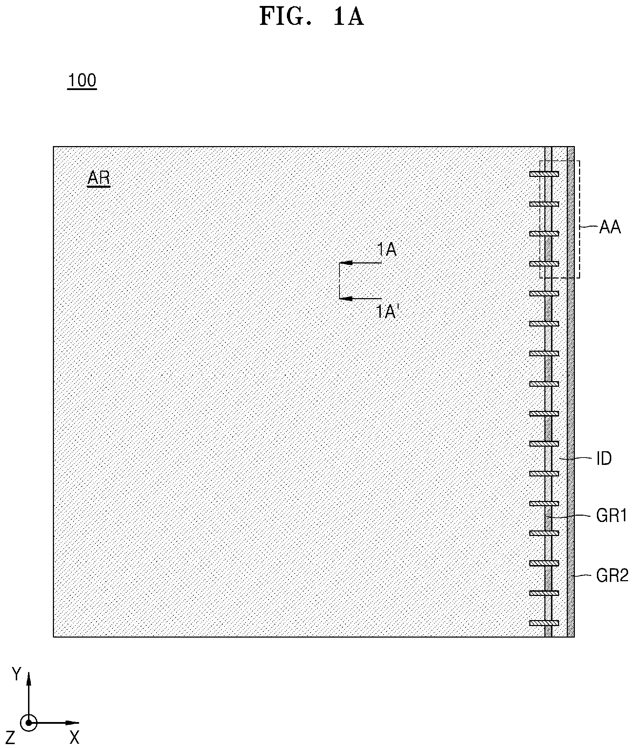

FIG. 1A is a plan view illustrating an integrated circuit 100 according to some embodiments.

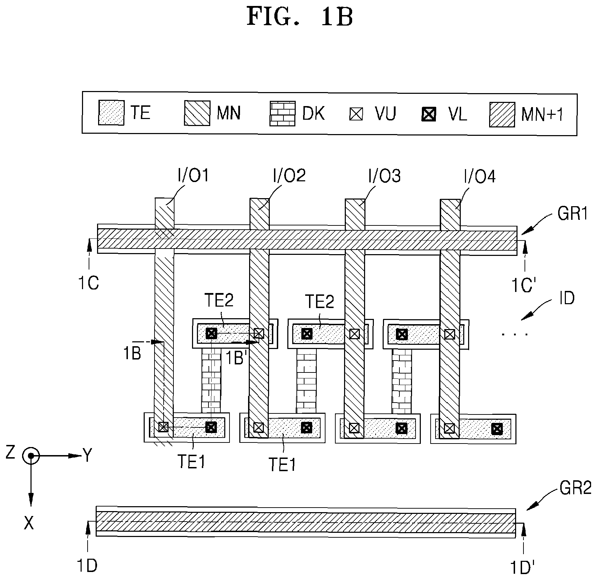

FIG. 1B is a plan view of a portion AA of FIG. 1A;

Referring to FIGS. 1A and 1B, the integrated circuit 100 may include an active area AR, an inductive element ID, a plurality of input/output wires I/O1, I/O2, I/O3, and I/O4, a first guard ring GR1, and a second guard ring GR2.

Hereinafter, the plane made up of the X and Y axes may be referred to as a horizontal plane, an element disposed in the +Z direction relative to other elements may be referred to as being above the other elements, and elements disposed in the -Z direction relative to other elements may be referred to as being below the other elements. In addition, the area of an element may refer to a size occupied by the element on a plane parallel to the horizontal plane, and the height of the element may refer to a length of the element in the Y-axis direction. The X, Y, and Z directions may be substantially perpendicular to each other. In the following drawings, upper vias VU and lower vias VL may be shown to clarify the connection relationship even when disposed below other elements.

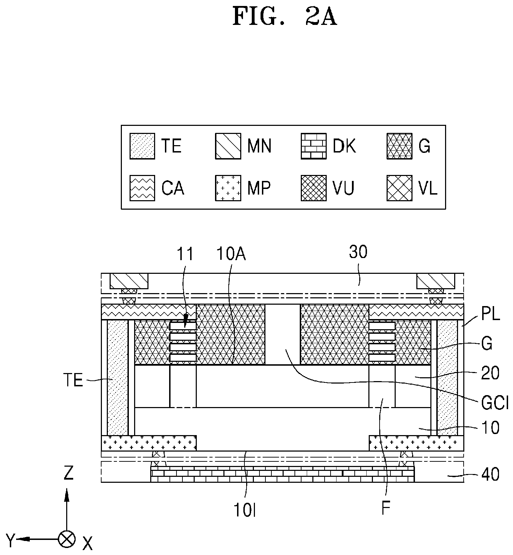

Here, metallization patterns are conductive patterns and conductive pads, which may extend horizontally and may be formed in a back end of line (BEOL) process. Vias are conductive elements that may extend vertically to connect adjacent patterns. A 'contact' is a conductive element for electrical connection with structures (e.g., a source/drain, a gate, etc. of a transistor) formed on the front end of line (FEOL). The 'contact' may be used for electrical connection with a structure formed in a substrate 10 (see FIG. 2A), such as through electrodes.

Complementary metal-oxide-semiconductor (CMOS) transistors for constituting logic circuits, such as a graphics processing unit (GPU) and an application processor (AP) may be disposed in the active region AR. According to some embodiments, static random access memory (SRAM) may be formed in the active region AR. A plurality of standard cells may be arranged on the active region AR. The standard cells are pre-designed logic devices used to speed up the design of integrated circuits. A standard cell includes one or more transistors.

The inductive element ID may extend in the Y direction. The inductive element ID may be disposed at one end of the active region AR in the X direction. The inductive element ID may extend in a horizontal direction (e.g., Y direction). According to some embodiments, the inductive element ID may have a winding axis in a horizontal direction (e.g., Y direction).

Here, the X direction may be an extension direction of a power line, such as a ground rail or a power rail, and the Y direction may be an extension direction of a gate of a transistor. Accordingly, a power line (e.g., a ground rail or a power rail) may extend longitudinally in the X direction, and a gate of a transistor may extend longitudinally in the Y direction.

According to some embodiments, the inductive element ID may be an impedance matching circuit. In this case, the inductive element ID may improve the energy efficiency and signal-to-noise ratio of the integrated circuit 100 by canceling parasitic impedance caused by structures (e.g., metallization layers and transistors) in the active region AR.

According to other embodiments, the inductive element ID may constitute an antenna. In this case, the inductive element ID may be configured to generate electromagnetic waves based on a signal applied from the active region.

In the case of a conventional inductive element, the winding axis thereof is parallel to the Z direction and the inductive element has a predetermined length in each of the X and Y directions. Predetermined lengths in the X and Y directions define the cross-sectional area of conventional inductive elements. Accordingly, the conventional inductive element has a large area horizontally and causes a decrease in the degree of integration of an integrated circuit.

The inductive element ID of the integrated circuit 100 according to some embodiments has a winding axis in a horizontal direction and is disposed at the edge of the active region AR and extends along the edge of the active region AR, and thus, despite the formation of the inductive element ID, the change in the area of the integrated circuit 100 is very small. Accordingly, the degree of integration of the integrated circuit 100 may be improved.

FIG. 2A is a cross-sectional view taken along the cutting line 1A-1A' in FIG. 1A.

Referring to FIGS. 1A and 2A, the integrated circuit 100 may include a substrate 10 and a field insulating layer 20 disposed on the substrate 10.

According to some embodiments, the substrate 10 may be bulk silicon. As a non-limiting example, the substrate 10 may include SiGe, InSb, PbTe compounds, InAs, phosphide, GaAs, GaSb, or the like.

The substrate 10 may include a first well region and a second well region. According to some embodiments, the first well region and the second well region may have different conductivity types. According to some embodiments, the first well region may be doped with a P-type dopant, and the second well region may be doped with an N-type dopant. N-type MOSFETs may be disposed in the first well region, and P-type MOSFETs may be disposed in the second well region. However, it is not limited thereto, and each of the first and second well regions may be doped with a P-type dopant.

In the drawings of the present specification, only some layers may be shown for convenience of illustration, and upper and lower vias VL and VU may be displayed despite being located under the pattern of the wiring layer to indicate a connection between the pattern of the wiring layer and the lower pattern.

The field insulating layer 20 may be disposed on the substrate 10. The field insulating layer 20 may include, as non-limiting examples, any one of SiO₂, SiN, SiON, SiOCN, and combinations thereof. In some embodiments, the field insulating layer 20 may define an active pattern F. In some embodiments, the field insulating layer 20 may surround side surfaces of the active pattern F.

The active patterns F may extend in the X direction. In some cases, a device isolation layer extending in the X direction may be between the active patterns F. The device isolation layer may separate the active patterns F from each other.

Channel regions 11 and source and drain regions (not shown) may be disposed on the active patterns F. The channel regions 11 may overlap the gate electrodes G vertically (e.g., in the Z direction). Source/drain regions may be disposed adjacent to the channel regions 11. The source/drain regions may be spaced apart from each other with the channel regions 11 therebetween. The source/drain regions may not vertically overlap the gate electrodes G. In FIG. 2A, an upper contact CA may appear to be in contact with the gate electrode G and the channel regions 11, but this is because structures disposed at different positions in the X direction are expressed at once, and the upper contact CA does not directly contact the gate electrode G and the channel regions 11. The upper contact CA may contact at least one of an upper surface and a side surface of a source/drain region (not shown) formed adjacent to the channel in the X direction penetrating the drawing in FIG. 2A.

The channel regions 11 may include, for example, a semiconductor material. According to some embodiments, the channel regions 11 may be a silicon layer or a silicon germanium layer provided by an epitaxial growth process or the like. According to some embodiments, the channel regions 11 may be doped to have a conductivity type that is different from that of neighboring source/drain regions. For example, the channel regions 11 adjacent to N-type source/drain regions may be doped with P-type dopants, and the channel regions 11 adjacent to P-type source-drain regions may be doped with N-type dopants.

Although briefly shown, the channel regions 11 may have a multi-bridge channel (MBC) structure. For example, the channel regions 11 may include a plurality of nanosheets spaced apart from each other in the Z-axis direction and extending in the X-axis direction, and the plurality of nanosheets may be surrounded by the gate electrode G. This structure is called gate all around.

However, this is for illustrative purposes only and the technical idea of the inventive concept is not limited thereto. A person skilled in the art may easily understand that an integrated circuit according to the embodiments may be composed of transistors having a structure that is different from that of multi bridge channel FET(MBCFET). The integrated circuit may include a FinFET structure including a fin-shaped channel region. Alternatively, the integrated circuit may include a ForkFET having a structure in which an N-type transistor and a P-type transistor are closer together by separating nanosheets for the P-type transistor and nanosheets for the N-type transistor from each other by a dielectric wall. In some embodiments, a cell may include a vertical FET (VFET) having a structure in which source/drain regions are spaced apart from each other in the Z-axis direction with a channel region therebetween and a gate electrode surrounds the channel region. In some embodiments, the integrated circuit may include a field effect transistor (FET), such as a complementary FET (CFET), a negative capacitance FET (NCFET), a carbon nanotube (CNT) FET, and the like, and may also include bipolar junction transistors and other three-dimensional transistors.

The gate electrodes G may extend in the Y direction. A gate cut insulating layer GCI may be between the gate electrodes G. The gate cut insulating layer GCI may separate the gate electrodes G in the Y direction. The gate cut insulating layer GCI may fill a gate cut region for separately operating the gate electrodes G arranged in a row in the Y direction.

The gate electrodes G may extend in the Y direction across the channel regions 11. The gate electrodes G may further include portions disposed on the field insulating layer 20.

The gate electrodes G may include a gate conductive layer, gate spacers disposed on both sides of the gate conductive layer, a gate dielectric layer on a lower surface of the gate conductive layer, and a silicide layer covering an upper surface of the gate conductive layer.

According to some embodiments, the gate dielectric layer may include a high-k material. The dielectric constant of the gate dielectric layer may be greater than the dielectric constant of silicon nitride. For example, the dielectric constant of the gate dielectric layer may be 10 or more. According to some embodiments, the gate dielectric layer may include at least one of hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, but is not limited thereto.

According to some embodiments, the gate conductive layer may include a metal material. For example, the gate conductive layer may include Ti, Ta, W, Al, Co, or a combination thereof. In another example, the gate conductive layer may include a semiconductor material, such as Si or SiGe. In another example, the gate conductive layer may include a multilayer structure in which two or more conductive materials are stacked. For example, the gate conductive layer may include a conformal deposition structure of a work function regulating layer including any one of TiN, TaN, TiC, TaC, TiAlC, and combinations thereof and a filling conductive layer including W or Al, which fills the inside of the conformal deposition structure of the work function regulating layer.

According to some embodiments, the gate spacer may include an insulating material. The gate spacer may include, for example, silicon nitride, such as Si₃N₄. The gate spacer may cover side surfaces of the gate conductive layer. Accordingly, an unwanted/unintended short circuit to the gate conductive layer and material diffusion from the gate conductive layer may be reduced/prevented.

The gate silicide layer may include a metal silicide material. The gate silicide layer may reduce contact resistance between the gate electrode G and the gate contact (not shown).

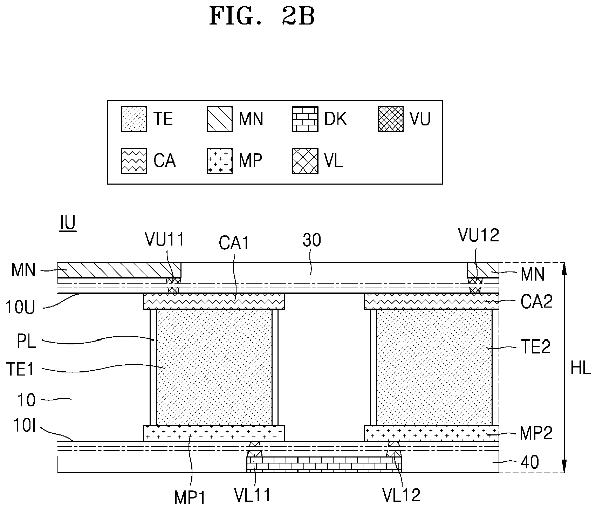

According to some embodiments, the through electrodes TE may extend in the Z direction. According to some embodiments, the through electrodes TE may penetrate the substrate 10 in the Z direction. The Z direction may be perpendicular to an upper surface 10U of the substrate 10 (see FIG. 2B), an active surface 10A of the substrate 10, and an inactive surface 10I of the substrate 10, respectively. The active surface 10A of the substrate 10 is a surface on which semiconductor elements such as MBCFETs are formed, and the inactive surface 10I of the substrate 10 is opposite to the active surface 10A. The upper surface 10U (see FIG. 2B) of the substrate 10 may be spaced apart from the inactive surface 10I of the substrate 10 with the active surface 10A of the substrate 10 therebetween. The active surface 10A may be between the upper surface 10U (see FIG. 2B) and the inactive surface 10I. The inactive surface 10I may be referred to as a lower surface of the substrate 10 in some cases.

The through electrodes TE may be between first upper metallization patterns MN and first lower metallization patterns DK. The through electrodes TE may be connected to the first upper metallization patterns MN and the first lower metallization patterns DK. The through electrodes TE may be configured to electrically connect the first upper metallization patterns MN to the first lower metallization patterns DK. Accordingly, in designing the power grid of the active region AR, it is possible to use the wiring structures formed on the active surface 10A and the inactive surface 10I of the substrate 10, respectively, and thus the resistance of the wiring structure may be reduced and thus voltage drop thereof may be reduced/prevented.

A passivation layer PL may be disposed on side surfaces of the through electrodes TE. The passivation layer PL may have a uniform thickness. The passivation layer PL may surround side surfaces of the through electrodes TE. The passivation layer PL may include an insulating material. The passivation layer PL may reduce/prevent an inadvertent short circuit between conductive elements adjacent to the through electrodes TE and the through electrodes TE.

Ends (e.g., ends adjacent to the active surface 10A) of the through electrodes TE may contact the upper contact CA. The other ends (e.g., ends adjacent to the inactive surface 10I) of the through electrodes TE may contact the lower contact MP.

The upper contacts CA may be, for example, source-drain contacts, but are not limited thereto. The lower contacts MP may connect the first lower metallization patterns DK to the through electrodes TE. The through electrodes TE may extend from the upper contacts CA to the lower contacts MP.

According to some embodiments, upper contacts CA, upper vias VU, and first upper metallization patterns MN may be disposed on the active surface 10A of the substrate 10. The second contacts MP, lower vias VL, and first lower metallization patterns DK may be disposed on the inactive surface 10I of the substrate 10. The upper metallization pattern and the lower metallization pattern may each be formed on a plurality of layers, and the layers on which the upper metallization pattern and the lower metallization pattern are formed may alternate with insulating layers (not shown). Upper metallization patterns of each layer may be connected to upper metallization patterns positioned on adjacent layers through vias (not shown). Lower metallization patterns of each layer may also be connected to lower metallization patterns located in adjacent layers through vias (not shown). The first upper metallization patterns MN are metallization patterns disposed on the N-th (N is an integer greater than or equal to 1) layer on the active surface 10A of the substrate 10, and the first lower metallization patterns DK may be metallization patterns disposed on a K-th (K is an integer greater than or equal to 1) layer on the inactive surface 10I of the substrate 10. According to some embodiments, N and K may each be an integer of 10 or less. The first upper metallization patterns MN and the first lower metallization patterns DK may be relatively adjacent to the active region AR compared to other upper metallization patterns and other lower metallization patterns so that N and K are 10 or less, respectively. Accordingly, signal loss in signal transmission to the inductive element ID, which is described below, may be alleviated.

Each of the upper contacts CA, the upper vias VU, and the first upper metallization patterns MN may be spaced apart from each of the second contacts MP, the lower vias VL, and the first lower metallization patterns DK with the substrate 10 therebetween. An insulating material may be between the upper contact CA and the lower contact MP and the substrate 10. Accordingly, an unintentional short circuit between the upper contacts CA and the lower contacts MP and the substrate 10 may be reduced/prevented. When the conductive transmittance control layer is disposed adjacent to one of the upper contact CA and the first lower contact MP, an insulating material may be between the conductive transmittance control layer and the upper contact CA and between the conductive transmittance control layer and the lower contact MP.

An upper insulating layer 30 may be disposed on the active surface 10A of the substrate 10. The upper insulating layer 30 may cover the upper contacts CA, the upper vias VU, and the first upper metallization patterns MN. The upper insulating layer 30 may cover the channel regions 11, the source/drain regions, and the gate electrode G.

The lower insulating layer 40 may be disposed on the inactive surface 10I of the substrate 10. The lower insulating layer 40 may cover the second contacts MP, the lower vias VL, and the first lower metallization patterns DK of the substrate 10.

The upper insulating layer 30 and the lower insulating layer 40 may include a low dielectric material. The upper insulating layer 30 and the lower insulating layer 40 may include, for example, silicon oxide. The upper insulating layer 30 and the lower insulating layer 40 may include, for example, Plasma Enhanced Oxide (PEOX), TetraEthyl OrthoSilicate (TEOS), Boro TetraEthyl OrthoSilicate (BTEOS), Phosphorous TetraEthyl OrthoSilicate (PTEOS), Boro Phospho TetraEthyl OrthoSilicate (BPTEOS), Boro Silicate Glass (BSG), Phospho Silicate Glass (PSG), Boro Phospho SilicateGlass (BPSG), and the like.

FIG. 2B is a cross-sectional view taken along the cutting line 1B-1B' in FIG. 1B. In more detail, FIG. 2B shows a portion IU corresponding to one winding of the inductive element ID. Accordingly, the portion IU shown in FIG. 2B may be a unit inductor included in the inductive element ID.

Dashed-dotted lines in FIG. 2A and the figures that follow indicate that one or more metallization patterns and vias may be omitted therebetween.

Referring to FIGS. 1B and 2B, the portion IU of the inductive element ID may include a first upper metallization pattern MN, a first upper via VU11, a first upper contact CA1, a first through electrode TE1, a first lower contact MP1, a first lower via VL11, a first lower metallization pattern DK, a first lower via VL12, a second lower contact MP2, a second through electrode TE2, a second upper contact CA2, and a first upper via VU12.

According to some embodiments, the current introduced through the first upper metallization pattern MN of the inductive element ID may flow sequentially through the first upper via VU11, the first through electrode TE1, the first lower contact MP1, the first lower via VL11, the first lower metallization pattern DK, the first lower via VL12, the second lower contact MP2, the second through electrode TE2, the second upper contact CA2, and the first upper via VU12.

The inductive element ID may have a structure in which portions IU formed along the cutting line 1B-1B' are repeated. Both ends of each of the portions IU of the inductive element ID may be connected to a plurality of input/output wires I/O1, I/O2, I/O3, and I/O4 implemented with the first upper metallization pattern MN. Each of the portions IU of the inductive element ID may be a portion between a plurality of input/output wires I/O1, I/O2, I/O3, and I/O4. By selecting two of the plurality of input/output wires I/O, the size and location of the inductance of the inductive element ID between the selected plurality of input/output wires I/O1, I/O2, I/O3, and I/O4 may be determined.

The plurality of input/output wires I/O1, I/O2, I/O3, and I/O4 may be configured to electrically connect the inductive element ID to a logic circuit formed on the active region AR. A plurality of input/output wires I/O1, I/O2, I/O3, and I/O4 may be arranged in the Y direction.

That is, the inductive element ID includes a plurality of portions IU connected in series, and by selecting the number of portions IU used for generating magnetic flux, the inductive element may determine the operating inductance of the inductive element ID. Here, the operating inductance is a concept distinguished from effective inductance, and means inductance used for actual operation among the total inductance of the inductive element ID. The operating inductance may simply be interpreted as the inductance of the inductive element ID viewed from selected ones from among the plurality of input/output wires I/O1, I/O2, I/O3, and I/O4. In addition, each of the plurality of portions IU may be interpreted as a unit inductor.

For example, when selecting the input/output wires I/O1 and I/O3 (that is, when inputting and outputting electrical signals through the input/output wires I/O1 and I/O3), the operating inductance of the inductive element ID may be the series inductance of the two portions IU.

According to some embodiments, the planar shape (or horizontal cross-sectional shape) of each of the first and second through electrodes TE1 and TE2 may be a rectangle with a long side parallel to the Y direction and a short side parallel to the X direction. In this case, the planar shape of each of the first and second through electrodes TE1 and TE2 may include round corners due to limitations of the lithography process and the patterning process. As used herein, "a plane shape" may refer to a shape in a plan view.

The first through electrodes TE1 and the second through electrodes TE2 may extend in the Z direction. The first through electrodes TE1 and the second through electrodes TE2 may extend from the active surface 10A of the substrate 10 to the inactive surface 10I of the substrate 10 similar to the description with reference to FIGS. 1 and 2A. The first through electrodes TE1 and the second through electrodes TE2 may be horizontally surrounded by the substrate 10. The first through electrodes TE1 and the second through electrodes TE2 may be surrounded by the passivation layer PL. The first through electrodes TE1 and the second through electrodes TE2 may be spaced apart from the substrate 10 with the passivation layer PL therebetween.

A portion of the substrate 10 may be between the first through electrodes TE1 and the second through electrodes TE2. The portion of the substrate 10 between the first through electrodes TE1 and the second through electrodes TE2 may determine a permeability of the inductive element ID.

The first through electrodes TE1 may be aligned in the Y direction. The first through electrodes TE1 may be spaced apart from each other in the Y direction. The first through electrodes TE1 may be arranged in a row in the Y direction. A distance between each of the first through electrodes TE1 and the first guard ring GR1 may be greater than a distance between each of the first through electrodes TE1 and the second guard ring GR2. The first through electrodes TE1 may be spaced apart from the first guard ring GR1 with the second through electrodes TE2 therebetween.

The second through electrodes TE2 may be aligned in the Y direction. The second through electrodes TE2 may be spaced apart from each other in the Y direction. The second through electrodes TE2 may be arranged in a row in the Y direction. A distance between each of the second through electrodes TE2 and the second guard ring GR2 may be greater than a distance between each of the second through electrodes TE2 and the first guard ring GR1. The second through electrodes TE2 may be spaced apart from the second guard ring GR2 with the first through electrodes TE1 therebetween.

The first through electrodes TE1 may be spaced apart from the second through electrodes TE2 in the X direction. The first through electrodes TE1 may be alternately arranged with the second through electrodes TE2. Each of the first through electrodes TE1 may partially overlap the adjacent second through electrodes TE2 in the X direction. Each of the second through electrodes TE2 may partially overlap the adjacent first through electrodes TE1 in the X direction. At least some of the first through electrodes TE1 may partially overlap adjacent two of the second through electrodes TE2 in the X direction. At least some of the second through electrodes TE2 may partially overlap adjacent two of the first through electrodes TE1 in the X direction.

According to some embodiments, each of the first through electrodes TE1 and the second through electrodes TE2 may correspond to two tracks parallel to the Y direction. In order to include a structure in which the portions IU including the first through electrode TE1 extending in the Y direction and the second through electrode TE2 extending in the Y direction are three-dimensionally wound (i.e. to actually construct a portion of the coil), the first upper metallization pattern MN and the first lower metallization pattern DK of each of the portions IU of the inductive element ID may be spaced apart from each other in the Z direction with the first and second through electrodes TE1 and TE2 therebetween, and may overlap each other in the direction of the winding axis (i.e., the Y direction).

The first upper contact CA1 may contact the upper surface of the first through electrode TE1. The first lower contact MP1 may contact the lower surface of the first through electrode TE1. The second upper contact CA2 may contact the upper surface of the second through electrode TE2. The second lower contact MP2 may contact the lower surface of the second through electrode TE2.

In FIG. 2B, areas of the first upper contact CA1 and the first lower contact MP1 are greater than areas of the upper and lower surfaces of the first through electrode TE1, and the upper and lower surfaces of the first through electrode TE1 are completely covered by the first upper contact CA1 and the first lower contact MP1, respectively, but the inventive concept is not limited thereto. For example, the area of the first upper contact CA1 is less than the area of the upper surface of the first through electrode TE1, and an upper surface of the first through electrode TE1 may include a portion in contact with the upper insulating layer 30. In addition, the area of the first lower contact MP1 is less than the area of the lower surface of the first through electrode TE1, and the lower surface of the first through electrode TE1 may include a portion in contact with the lower insulating layer 40.

Similarly, unlike the illustration, the area of the second upper contact CA2 may be less than the area of the upper surface of the second through electrode TE2, and the upper surface of the second through electrode TE2 may include a portion in contact with the upper insulating layer 30. In addition, the area of the second lower contact MP2 may be less than the area of the lower surface of the second through electrode TE2, and the lower surface of the second through electrode TE2 may include a portion in contact with the lower insulating layer 40.

A first upper via VU11 may be between the first upper metallization pattern MN and the first upper contact CA1. The first upper metallization pattern MN may be connected to the first upper contact CA1 through the first upper via VU11.

The first lower via VL11 may be between the first lower metallization pattern DK and the first lower contact MP1. The first lower metallization pattern DK may be connected to the first lower contact MP1 through the first lower via VL11.

The first lower via VL12 may be between the first lower metallization pattern DK and the second lower contact MP2. The first lower metallization pattern DK may be connected to the first lower contact MP1 through the first lower via VL12.

The second upper via VU12 may be between the first upper metallization pattern MN and the second upper contact CA2. The first upper metallization pattern MN may be connected to the second upper contact CA2 through the second upper via VU12. The first upper metallization pattern MN and the first lower metallization pattern DK of the inductive element ID may extend in a direction perpendicular to the first and second through electrodes TE1 and TE2. In some embodiments, the first upper metallization pattern MN and the first lower metallization pattern DK of the inductive element ID may extend in a direction perpendicular to a direction in which the first and second through electrodes TE1 and TE2 extend. Each of the first upper metallization pattern MN and the first lower metallization pattern DK of each of the portions IU of the inductive element ID may extend in the X direction. Each of the first upper metallization pattern MN and the first lower metallization pattern DK may be spaced apart in the Y direction. Accordingly, the winding axis of each of the portions IU may be horizontal to the active surface 10A of the substrate 10. That is, the winding axis of the inductive element ID may be parallel to the Y direction.

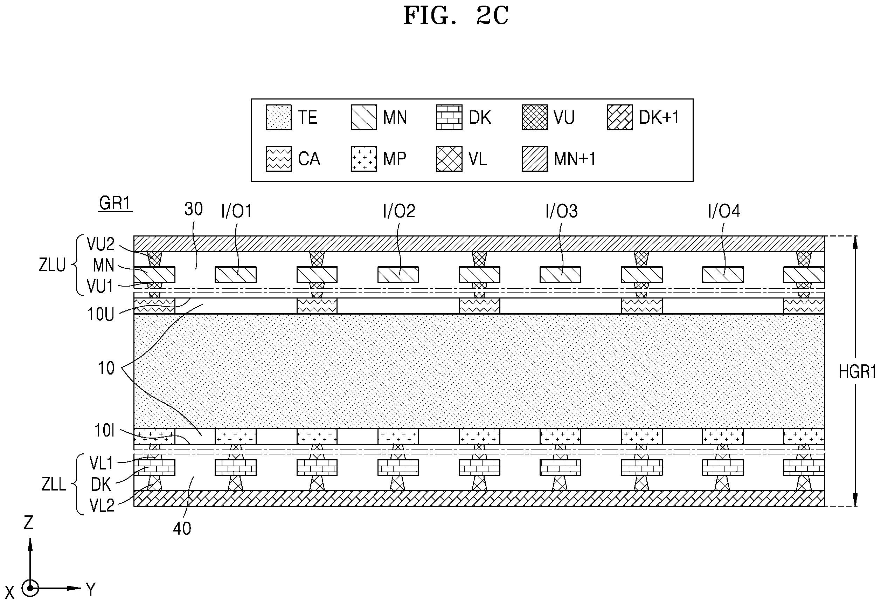

FIG. 2C is a cross-sectional view taken along the cutting line 1C-1C' in FIG. 1B.

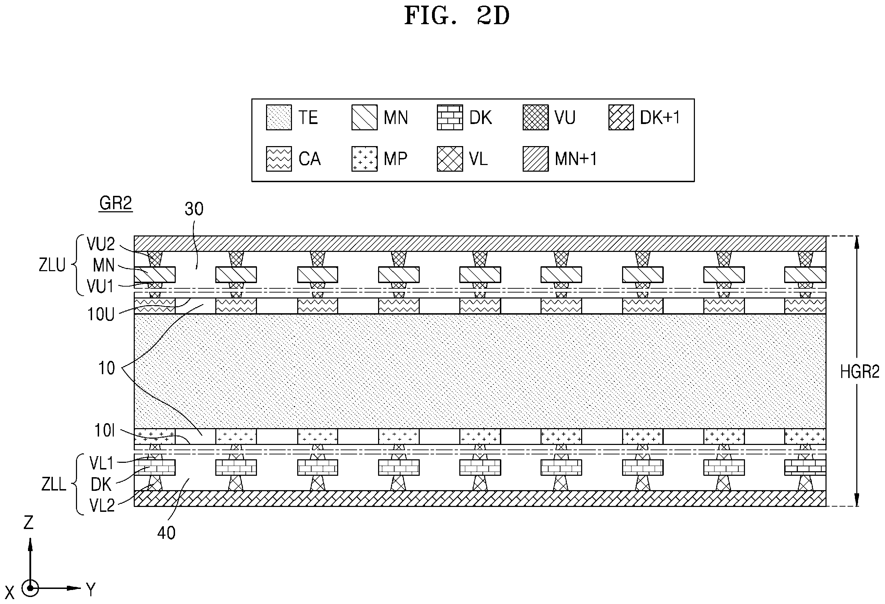

FIG. 2D is a cross-sectional view taken along the cutting line 1D-1D' in FIG. 1B.

Referring to FIGS. 1B, 2B, 2C, and 2D, the first and second guard rings GR1 and GR2 may extend in the Y direction. A length of each of the first and second guard rings GR1 and GR2 in the Y direction may be greater than or equal to the length of the inductive element ID in the Y direction. The first and second guard rings GR1 and GR2 may horizontally surround the inductive element ID. The inductive element ID may overlap each of the first and second guard rings GR1 and GR2 in the X direction over the entire extending direction.

Each of a first height HGR1 of the first guard ring GR1 and a second height HGR2 of the second guard ring GR2 may be equal to or greater than a height HL of the inductive element ID. For example, when the uppermost element of the inductive element ID is the first upper metallization pattern MN and the lowermost element of the inductive element is the first lower metallization pattern DK, the first and second guard rings GR1 and GR2 may include a first upper metallization pattern MN, a first lower metallization pattern DK, and conductive elements (i.e., upper via VU, upper contact CA, through electrode TE, lower contact MP and lower via VL) therebetween. The through electrode TE included in the first and second guard rings GR1 and GR2 may be referred to as a guard ring through electrode.

According to some embodiments, the first and second guard rings GR1 and GR2 may further include a second upper metallization pattern MN+1 farther from the substrate 10 than the first upper metallization pattern MN that is the uppermost element of the inductive element ID. The first and second guard rings GR1 and GR2 may include a second lower metallization pattern DK+1 farther from the substrate 10 than the first lower metallization pattern DK which is a lowermost element of the inductive element ID.

The first and second guard rings GR1 and GR2 may include a mesh structure. Here, the mesh structure means a structure in which a plurality of lines extending in different directions (e.g., directions perpendicular to each other) are connected to each other, like a net.

Each of the first upper metallization patterns MN and the first lower metallization patterns DK included in the first and second guard rings GR1 and GR2 may have an island shape. Here, the island shape is used in contrast to the line shape. For example, among the features, those having a length in the extension direction longer than the width may be said to have a line shape, and among the features, those having similar lengths in two mutually perpendicular horizontal directions (e.g., X and Y directions) may be said to have an island shape. As used herein, "extension direction" may refer to "longitudinal direction."

Hereinafter, when the extension direction of each feature is equal to or less than about 4 times the minimum pitch of the length perpendicular to the extension direction, the feature is defined to have an island shape. In addition, when the direction of extension of each feature exceeds about 4 times the minimum pitch of the length perpendicular to the direction of extension, the corresponding feature is defined to have a line shape. When a feature A has a length in the extension direction, which is equal to or shorter than about 4 times a pitch (e.g., a minimum pitch) of those features A in a direction perpendicular to the extension direction, that feature A may be said to have an island shape. When each feature B has a length in the extension direction, which is longer than about 4 times a pitch (e.g., a minimum pitch) of those features B in a direction perpendicular to the extension direction, that feature B may be said to have a line shape.

For example, the first upper metallization patterns MN are patterns extending in the X direction, and thus, a direction perpendicular to the extending direction may be a Y direction. In this case, among the first upper metallization patterns MN, those of which the length in the X direction is less than 4 times the minimum pitch MNP, which is the minimum repetition length of the first upper metallization patterns MN, may be referred to as having an island shape. In addition, among the first upper metallization patterns MN, those of which the length in the X direction exceeds 4 times the minimum pitch MNP, which is the minimum repetition length of the first upper metallization patterns MN, may be referred to as having a line shape.

In detail, the plurality of input/output wires I/O1, I/O2, I/O3, and I/O4 may have a line shape, and the upper metallization patterns MN of the inductive element ID may have a line shape. The upper metallization patterns MN of the first guard ring GR1 that are not connected to the inductive element ID may have an island shape.

As another example, the first lower metallization patterns DK are patterns extending in the X direction, and thus, a direction perpendicular to the extending direction may be a Y direction. In this case, among the first lower metallization patterns DK, those of which the length in the X direction is less than or equal to 4 times the minimum pitch DKP, which is the minimum repetition length of the first lower metallization patterns DK, may be referred to as having an island shape. In addition, among the first lower metallization patterns DK, those of which the length in the X direction exceeds 4 times the minimum pitch DKP, which is the minimum repetition length of the first lower metallization patterns DK, may be referred to as having a line shape. In detail, the lower metallization patterns DK of the inductive element ID may have a line shape, and the lower metallization patterns DK of the first guard ring GR1 may have an island shape.

The sequentially stacked upper contacts CA, first upper vias VU1, first upper metallization patterns MN having an island shape, and second upper vias VU2 of each of the first and second guard rings GR1 and GR2 may constitute a plurality of upper Z lines ZLU extending in the Z direction. The second upper metallization pattern MN+1 of each of the first and second guard rings GR1 and GR2 may have a line shape extending in the Y direction, and may be referred to as a first upper Y line. The second upper metallization pattern MN+1, the plurality of upper Z lines ZLU, and the through electrode TE may constitute the aforementioned mesh structure.

Similarly, the sequentially stacked lower contacts MP, first lower vias VL1, island-shaped first lower metallization patterns DK, and the second lower vias VL2 of each of the first and second guard rings GR1 and GR2 may form a plurality of lower Z lines ZLL extending in the Z direction. The second lower metallization pattern DK+1 of each of the first and second guard rings GR1 and GR2 may have a line shape extending in the Y direction and may be referred to as a first lower Y line. The second lower metallization pattern DK+1, the plurality of lower Z lines ZLL, and the through electrode TE may constitute the aforementioned mesh structure.

According to some embodiments, each of the plurality of input/output wires I/O1, I/O2, I/O3, and I/O4 may pass through the first guard ring GR1 and extend in the X direction toward the active region AR (refer to FIG. 1A). Each of the plurality of input/output wires I/O1, I/O2, I/O3, and I/O4 may be surrounded by the second upper metallization pattern MN+1, the plurality of upper Z lines ZLU, and the through electrode TE.

Each of the plurality of input/output wires I/O1, I/O2, I/O3, and I/O4 may be spaced apart from the second upper metallization pattern MN+1, the plurality of upper Z lines ZLU, and the through electrode TE. Each of the plurality of input/output wires I/O1, I/O2, I/O3, and I/O4 may contact a portion of the upper insulating layer 30 surrounded by the second upper metallization pattern MN+1, the plurality of upper Z lines ZLU, and the through electrode TE. Each of the plurality of input/output wires I/O1, I/O2, I/O3, and I/O4 may be insulated from the second upper metallization pattern MN+1, the plurality of upper Z lines ZLU, and the through electrode TE by the upper insulating layer 30.

The first and second guard rings GR1 and GR2 may be configured to reduce or block magnetic flux generated by the inductive element ID from being transferred to the active region AR. The first and second guard rings GR1 and GR2 may be configured to shield the active region AR from magnetic flux generated by the inductive element ID. According to some embodiments, an extension direction of the first and second guard rings GR1 and GR2 may be parallel to a direction (e.g., a Y direction) of a winding axis of the inductive element ID.

The inductive element ID may be between the first and second guard rings GR1 and GR2. The first and second guard rings GR1 and GR2 may be spaced apart from each other with the inductive element ID therebetween. The first guard ring GR1 may be closer to the active region AR (refer to FIG. 1A) than the second guard ring GR2. The second guard ring GR2 may be spaced apart from the active region AR (refer to FIG. 1A) with the first guard ring GR1 therebetween.

The first guard ring GR1 may have a shape that is different from that of the second guard ring GR2. As in the present example, when the first upper metallization pattern MN includes a plurality of input/output wires I/O1, I/O2, I/O3, and I/O4, the first upper metallization patterns MN of the first guard ring GR1 may be disposed in a density that is different from that of the first upper metallization patterns MN of the second guard ring GR2. The first upper metallization patterns MN of the first guard ring GR1 may be disposed at a lower density than the first upper metallization patterns MN of the second guard ring GR2.

The number of first upper metallization patterns MN included in the first guard ring GR1 may be different from the number of first upper metallization patterns MN included in the second guard ring GR2. The number of first upper metallization patterns MN included in the first guard ring GR1 may be less than the number of first upper metallization patterns MN included in the second guard ring GR2.

The number of upper Z lines ZLU included in the first guard ring GR1 may be different from the number of upper Z lines ZLU included in the second guard ring GR2. The number of upper Z lines ZLU included in the first guard ring GR1 may be less than the number of upper Z lines ZLU included in the second guard ring GR2.

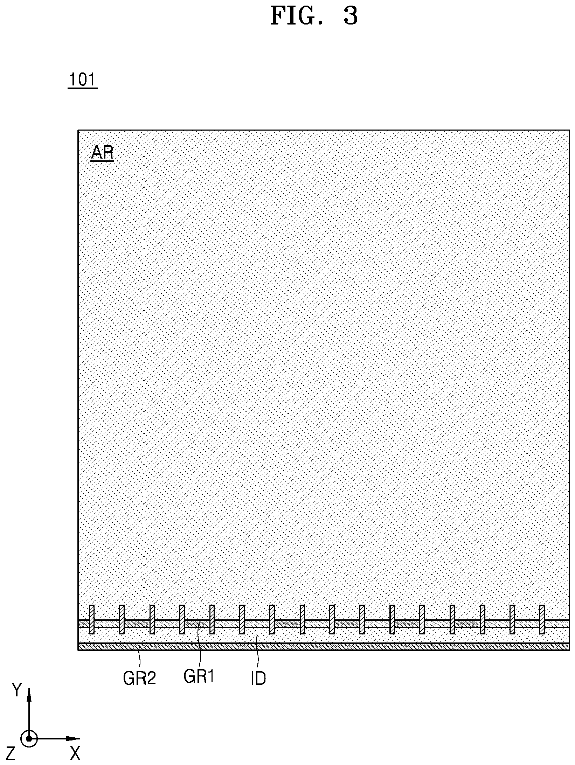

FIG. 3 is a plan view illustrating an integrated circuit 101 according to some other embodiments.

Referring to FIG. 3, the integrated circuit 101 may include an active region AR, an inductive element ID, input/output wires I/O, a first guard ring GR1, and a second guard ring GR2.

The active region AR is substantially the same as that described with reference to FIG. 1A.

The inductive element ID, the first guard ring GR1, and the second guard ring GR2 are substantially the same as those described with reference to FIG. 1A except that they extend perpendicular (i.e., in the X direction) to the extending direction of the gate electrode G (see FIG. 2A).

According to some embodiments, the arrangement of the inductive element ID, the first guard ring GR1, and the second guard ring GR2 in the active region AR may be variously changed depending on the position of the active region AR requiring impedance matching and a designed antenna position.

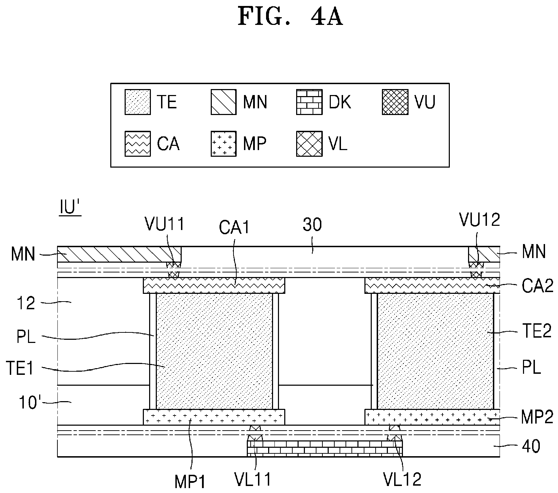

FIGS. 4A to 4D are diagrams illustrating portions IU', IU", IU‴, and IU"" of an inductive element ID (see FIG. 1B) according to some other embodiments. FIGS. 4A to 4D show portions corresponding to those in FIG. 2B.

Referring to FIGS. 4A to 4D, each of the portions IU', IU", IU"', and IU"" may include a first upper metallization pattern MN, a first upper via VU11, and a first upper contact CA1, a first through electrode TE1, a first lower contact MP1, a lower via VL11, a first lower metallization pattern DK, a lower via VL12, a second lower contact MP2, a second through electrode TE2, a second upper contact CA2, and a first upper via VU12.

Because the first upper metallization pattern MN and the first upper via VU11, the first upper contact CA1, the first through electrode TE1, the first lower contact MP1, the lower via VL11, the first lower metallization pattern DK, the lower via VL12, the second lower contact. MP2, the second through electrode TE2, the second upper contact CA2, and first upper via VU12 included in each of the portions IU', IU", IU‴, and IU"" are substantially the same as those described with reference to FIGS. 2A and 2B, descriptions thereof are omitted.

Referring to FIG. 4A, a portion of a substrate 10' may be between the first and second through electrodes TE1 and TE2. The portion of the substrate 10' may cover lower portions of the first and second through electrodes TE1 and TE2.

According to some embodiments, a permeability control layer 12 may further be between the first and second through electrodes TE1 and TE2. The permeability control layer 12 may be disposed on the substrate 10'. The permeability control layer 12 may surround upper portions of the first and second through electrodes TE1 and TE2.

According to some embodiments, the permeability control layer 12 may have a different permeability from that of the substrate 10'. In some embodiments, the permeability control layer 12 may have a greater permeability than the substrate 10'. In some other embodiments, the permeability control layer 12 may have a less permeability than that of the substrate 10'. The permeability control layer 12 may include a conductive material. For example, the permeability control layer 12 may include at least one of iron, nickel, cobalt, manganese, aluminum, and molybdenum. In some embodiments, the permeability control layer 12 may include an insulating material. For example, the permeability control layer 12 may include silicon oxide, silicon nitride, silicon oxynitride, silicon oxycarbonitride, or a combination thereof. In detail, the permeability control layer 12 may include any one of SiO₂, SiN, SiON, SiOCN, and combinations thereof.

According to some embodiments, the permeability control layer 12 may be formed by an etching process from the active surface 10A of the substrate 10' (see FIG. 2A). For example, in an etching process for forming the field insulating layer 20 of FIG. 1A, a portion of the substrate 10' in which the permeability control layer 12 is formed may be removed. Alternatively, in an etching process for forming a deep trench isolation (DTI), a portion of the substrate 10' in which the permeability control layer 12 is formed may be removed.

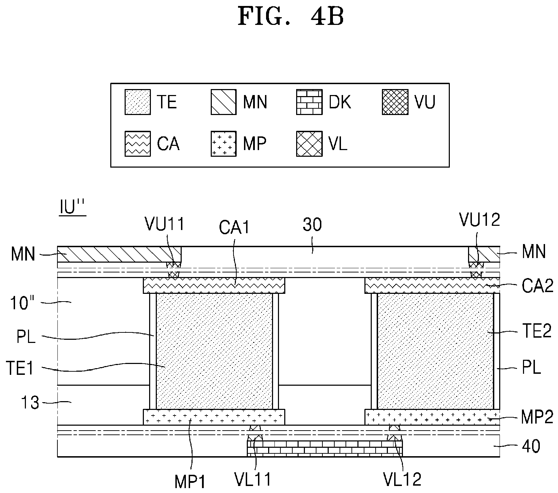

Referring to FIG. 4B, a portion of a substrate 10" may be between the first and second through electrodes TE1 and TE2. The portion of the substrate 10" may cover upper portions of the first and second through electrodes TE1 and TE2.

According to some embodiments, a permeability control layer 13 may further be between the first and second through electrodes TE1 and TE2. The permeability control layer 13 may be disposed below the substrate 10". The permeability control layer 13 may surround lower portions of the first and second through electrodes TE1 and TE2.

According to some embodiments, the permeability control layer 13 may have a permeability that is different from that of the substrate 10". In some embodiments, the permeability control layer 13 may have a greater permeability than the substrate 10". In some other embodiments, the permeability control layer 13 may have a less permeability than the substrate 10".

According to some embodiments, the permeability control layer 13 may be formed by an etching process from the inactive surface 10I (see FIG. 2A) of the substrate 10".

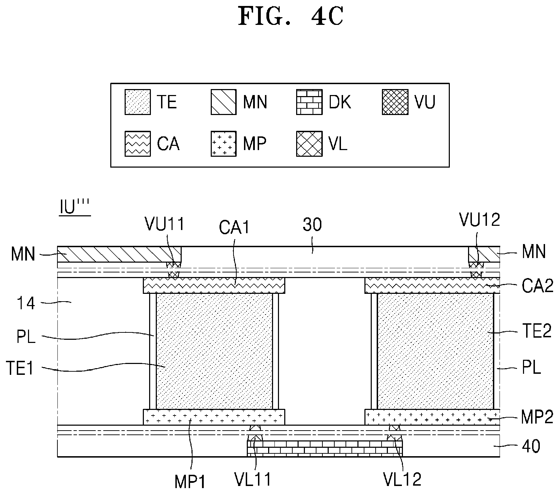

Referring to FIG. 4C, a permeability control layer 14 may be between the first and second through electrodes TE1 and TE2. The permeability control layer 14 may surround the first and second through electrodes TE1 and TE2 or partially cover the first and second through electrodes TE1 and TE2. Only the permeability control layer 14 may be between the first and second through electrodes TE1 and TE2. A portion of the substrate 10 (see FIG. 2A) may not be between the first and second through electrodes TE1 and TE2.

According to some embodiments, the permeability control layer 14 may have a permeability that is different from that of the substrate 10 (see FIG. 2A). In some embodiments, the permeability control layer 14 may have a greater permeability than that of the substrate 10 (see FIG. 2A). In some other embodiments, the permeability control layer 14 may have a less permeability than that of the substrate 10 (see FIG. 2A).

According to some embodiments, the permeability control layer 14 may be formed by an etching process from the active surface 10A (see FIG. 2A) of the substrate 10 (see FIG. 2A) and an etching process from the inactive surface 10I (see FIG. 2A) of the substrate 10 (see FIG. 2A).

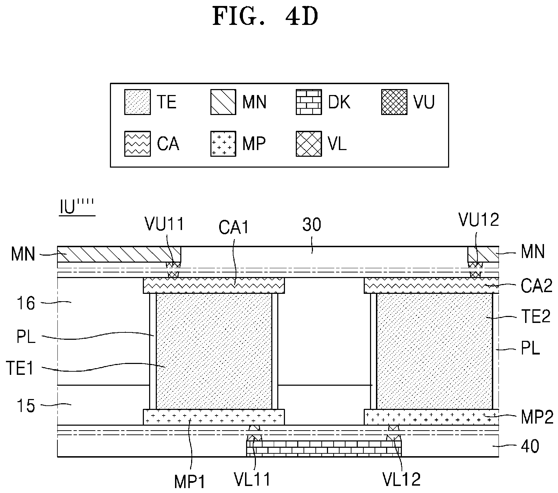

Referring to FIG. 4D, a lower permeability control layer 15 and an upper permeability control layer 16 may be between the first and second through electrodes TE1 and TE2. The lower permeability control layer 15 may surround lower portions of the first and second through electrodes TE1 and TE2. The upper permeability control layer 16 may surround upper portions of the first and second through electrodes TE1 and TE2.

According to some embodiments, the upper permeability control layer 16 and the lower permeability control layer 15 may have permeability that is different from that of the substrate 10 (see FIG. 2A). In some embodiments, the upper permeability control layer 16 and the lower permeability control layer 15 may have greater permeability than that of the substrate 10 (see FIG. 2A). In some other embodiments, the upper permeability control layer 16 and the lower permeability control layer 15 may have permeability less than that of the substrate 10 (see FIG. 2A). According to some embodiments, the permeability of each of the upper permeability control layer 16 and the lower permeability control layer 15 may be different from each other. According to some other embodiments, the permeability of the upper permeability control layer 16 and the lower permeability control layer 15 may be substantially the same as each other.

According to some embodiments, the upper permeability control layer 16 may be formed by an etching process from the active surface 10A (see FIG. 2A) of the substrate 10 (see FIG. 2A). According to some embodiments, the lower permeability control layer 15 may be formed by an etching process from the inactive surface 10I (see FIG. 2A) of the substrate 10 (see FIG. 2A).

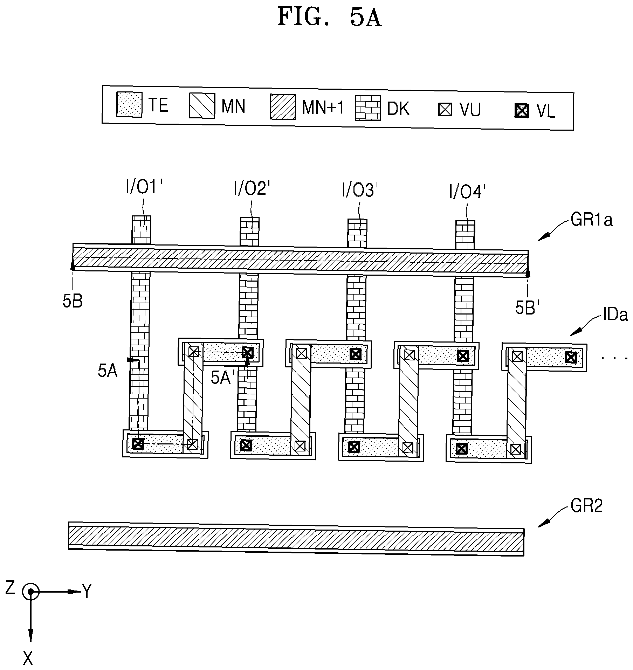

FIG. 5A is a diagram for explaining an inductive element IDa and a guard ring GR1a according to some other embodiments. In more detail, FIG. 5A shows a portion corresponding to FIG. 1B.

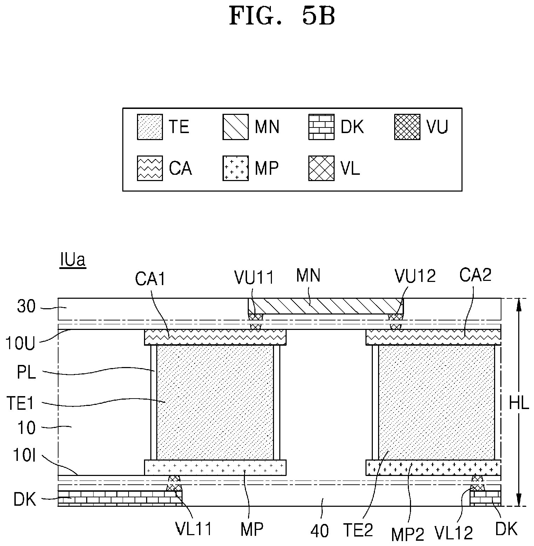

FIG. 5B is a cross-sectional view taken along the cutting line 5A-5A' in FIG. 5A.

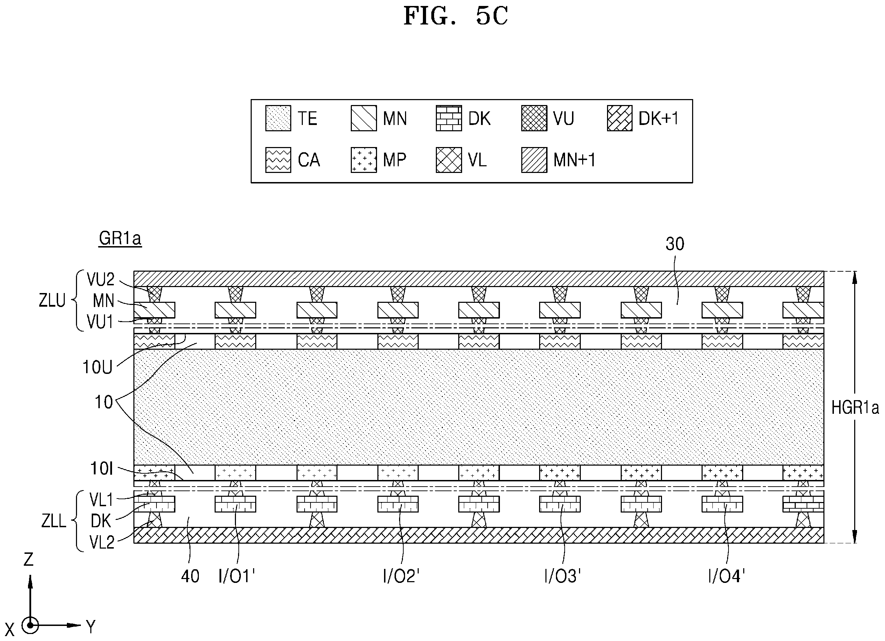

FIG. 5C is a cross-sectional view taken along the cutting line 5B-5B' in FIG. 5A.

For convenience of description, the descriptions already given with reference to FIGS. 1A to 2D are omitted, and differences from the description already given with reference to FIGS. 1A to 2D are described.

Referring to FIGS. 5A to 5C, input/output wires I/O1', I/O2', I/O3', and I/O4' connected to the inductive element IDa may be included in the first lower metallization patterns DK. Except for being connected to the input/output wires I/O1', I/O2', I/O3', and I/O4' formed of the first lower metallization patterns DK, the inductive element IDa may be substantially similar to the inductive element ID of FIG. 1B.

The first guard ring GR1a may include a mesh structure. Each of the first upper metallization patterns MN and the first lower metallization patterns DK included in the first guard ring GRla may have an island shape.

The first guard ring GR1a is substantially similar to the first guard ring GR1 of FIG. 2C except that the input/output wires I/O1', I/O2', I/O3', and I/O4' penetrating the first guard ring GR1a are formed of the first lower metallization patterns DK.

The second guard ring GR2 is substantially the same as that shown in FIG. 2D.

According to some embodiments, each of the plurality of input/output wires I/O1', I/O2', I/O3', and I/O4' may pass through the first guard ring GR1 to extend in the X direction toward the active region AR (refer to FIG. 1A). Each of the plurality of input/output wires I/O1', I/O2', I/O3', and I/O4' may be surrounded by the second lower metallization pattern DK+1, the plurality of lower Z lines ZLL, and the through electrode TE.

Each of the plurality of input/output wires I/O1', I/O2', I/O3', and I/O4' may be spaced apart from the second lower metallization pattern DK+1, the plurality of lower Z lines ZLL, and the through electrode TE. Each of the plurality of input/output wires I/O1', I/O2', I/O3', and I/O4' may contact a portion of the lower insulating layer 40 surrounded by the second lower metallization pattern DK+1, the plurality of lower Z lines ZLL, and the through electrode TE. Each of the plurality of input/output wires I/O1', I/O2', I/O3', and I/O4' may be insulated from the second lower metallization pattern DK+1, the plurality of lower Z lines ZLL, and the through electrode TE by the lower insulating layer 40.

The first guard ring GR1a may reduce/prevent magnetic flux generated by the inductive element ID from being transferred to the active region AR. According to some embodiments, an extending direction of the first guard ring GR1a may be parallel to a direction (e.g., a Y direction) of a winding axis of the inductive element ID.

The first guard ring GR1a may have a shape that is different from that of the second guard ring GR2. As in the present example, when the first lower metallization pattern DK includes a plurality of input/output wires I/O1', I/O2', I/O3', and I/O4', the first lower metallization patterns DK of the first guard ring GR1a may be disposed in a density different from that of the first lower metallization patterns DK of the second guard ring GR2 (refer to FIG. 2D). The first lower metallization patterns DK of the first guard ring GR1a may be disposed at a less density than the first lower metallization patterns DK of the second guard ring GR2 (refer to FIG. 2D).

The number of first lower metallization patterns DK included in the first guard ring GR1a may be different from the number of first lower metallization patterns DK included in the second guard ring GR2 (see FIG. 2D). In some embodiments, the number of first lower metallization patterns DK included in the first guard ring GR1a may be less than the number of first lower metallization patterns DK included in the second guard ring GR2 (see FIG. 2D).

The number of lower Z lines ZLL included in the first guard ring GR1a may be different from the number of lower Z lines ZLL included in the second guard ring GR2 (refer to FIG. 2D). In some embodiments, the number of lower Z lines ZLL included in the first guard ring GR1a may be less than the number of lower Z lines ZLL included in the second guard ring GR2 (refer to FIG. 2D).

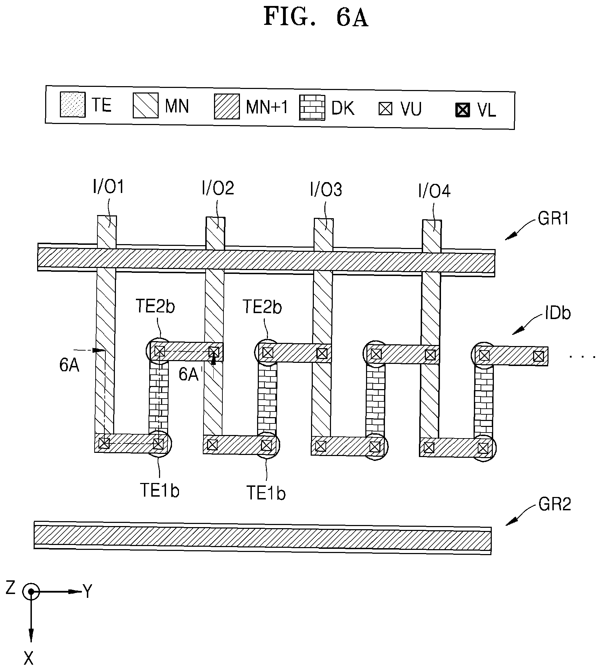

FIG. 6A is a diagram for explaining an inductive element IDb according to some other embodiments. In more detail, FIG. 6A shows a portion corresponding to FIG. 1B.

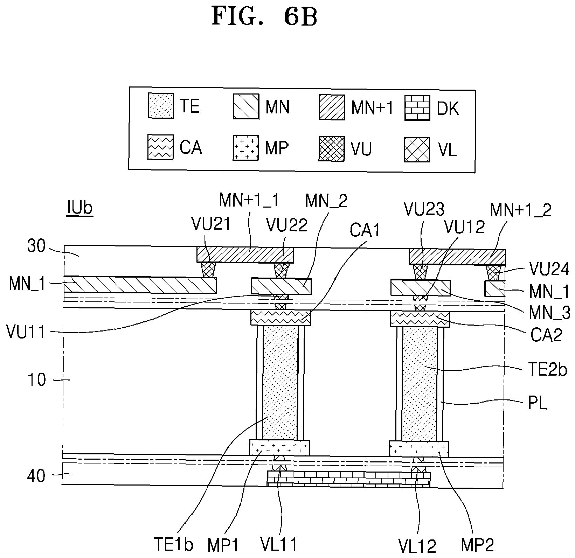

FIG. 6B is a cross-sectional view taken along the line 6A-6A' in FIG. 6A. In more detail, FIG. 6B shows a portion IUb corresponding to one winding of the inductive element IDb. The portion IUb shown in FIG. 6B may be a unit inductor included in the inductive element IDb.

Referring to FIGS. 6A and 6B, the portion IUb of the inductive element IDb may include a first upper metallization pattern MN_1, a second upper via VU21, a second upper metallization pattern MN+1_1, a second upper via VU22, a first upper metallization pattern MN_2, a first upper via VU11, a first upper contact CA1, a first through electrode TE1b, a first lower contact MP1, a lower via VL11, a first lower metallization pattern DK, a lower via VL12, a second lower contact MP2, a second through electrode TE2b, a second upper contact CA2, a first upper via VU12, a first upper metallization pattern MN_3, a second upper via VU12, an upper via VU23, a second upper metallization pattern MN+1_2, and a second upper via VU24.

According to some embodiments, a current introduced through the first upper metallization pattern MN_1 of the inductive element ID may sequentially flow through the second upper via VU21, the second upper metallization pattern MN+1_1, the second upper via VU22, the first upper metallization pattern MN_2, the first upper via VU11, the first upper contact CA1, the first through electrode TE1b, the first lower contact MP1, the lower via VL11, the first lower metallization pattern DK, the lower via VL12, the second lower contact MP2, the second through electrode TE2b, a second upper contact CA2, the first upper via VU12, the first upper metallization pattern MN_3, the second upper via VU12, the upper via VU23, the second upper metallization pattern MN+1_2, and the second upper via VU24.

The inductive element IDb may have a structure in which portions IUb formed along cutting line 6A-6A' are repeated. Both ends of each of the portions lUb of the inductive element IDb may be connected to a plurality of input/output wires I/O1, I/O2, I/O3, and I/O4 implemented on the first upper metallization pattern MN.

According to some embodiments, the first and second through electrodes TE1b and TE2b may have an island shape. According to some embodiments, planar shapes (or horizontal cross-sectional shapes) of the first and second through electrodes TE1b and TE2b may be circular.

In some embodiments, the planar shape (or the shapes of the horizontal cross section) of the first and second through electrodes TE1b and TE2b may be a quadrangle in which the Y-direction length and the X-direction length are substantially the same. In this case, the planar shape of each of the first and second through electrodes TE1b and TE2b may include round corners due to limitations of the lithography process and the patterning process.

In ultrafine processes, due to limitations in patterning, metallization patterns of adjacent metallization layers extend in one direction in a line-and-space form. For example, the first upper metallization patterns MN_1, MN_2, and MN_3 may extend in the X direction, while the second upper metallization patterns MN+1_1 and MN+1_2 may extend in the Y direction.

Accordingly, in this embodiment, the first and second through electrodes TE1b and TE2b have an island shape, and thus each of the portions lUb of the inductive element IDb may include second upper metallization patterns MN+1_1 and MN+1_2 extending in the Y direction to form windings in three dimensions. In this example, the first upper metallization patterns MN_2 and MN_3 may be pads for the second upper metallization patterns MN+1_1 and MN+1_2.

According to some embodiments, the first upper metallization pattern MN_1 and the first lower metallization pattern DK overlapping each other in the Y direction are spaced apart in the Z direction with the first and second through electrodes TE1b and TE2b therebetween, and thus each of the portions lUb of the inductive element IDb may include a three-dimensionally wound structure.

A portion of the substrate 10 may be between the first through electrodes TE1b and the second through electrodes TE2b.

The first through electrodes TE1b may be aligned in the Y direction. The first through electrodes TE1b may be spaced apart from each other in the Y direction. The first through electrodes TE1b may be arranged in a row in the Y direction. A distance between each of the first through electrodes TE1b and the first guard ring GR1 may be greater than a distance between each of the first through electrodes TE1b and the second guard ring GR2. The first through electrodes TE1b may be spaced apart from the first guard ring GR1 with the second through electrodes TE2b therebetween.

The second through electrodes TE2b may be aligned in the Y direction. The second through electrodes TE2b may be spaced apart from each other in the Y direction. The second through electrodes TE2b may be arranged in a row in the Y direction. A distance between each of the second through electrodes TE2b and the second guard ring GR2 may be greater than a distance between each of the second through electrodes TE2b and the first guard ring GR1. The second through electrodes TE2b may be spaced apart from the second guard ring GR2 with the first through electrodes TE1b therebetween.

The first through electrodes TE1b may be spaced apart from the second through electrodes TE2b in the X direction. The first through electrodes TE1b may be aligned with the second through electrodes TE2b in the X direction, respectively. Each of the first through electrodes TE1b may overlap a corresponding one of the adjacent second through electrodes TE2b in the X direction.

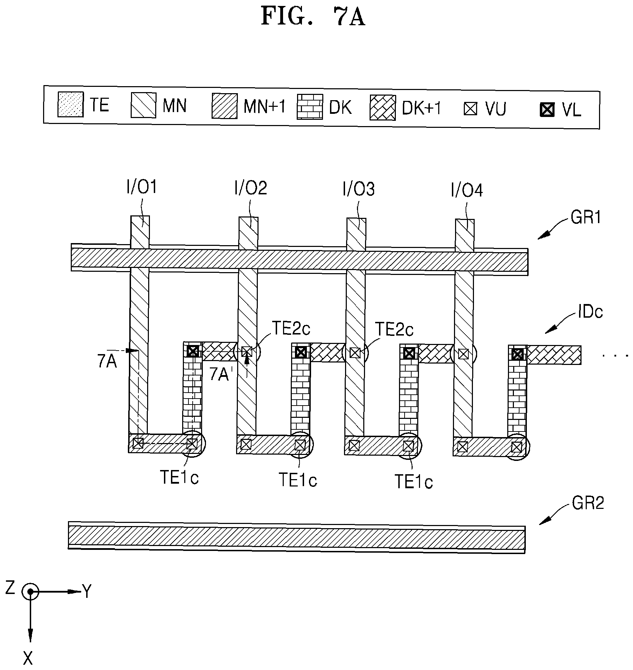

FIG. 7A is a diagram for explaining an inductive element IDc according to some other embodiments. In more detail, FIG. 7A shows a portion corresponding to FIG. 1B.

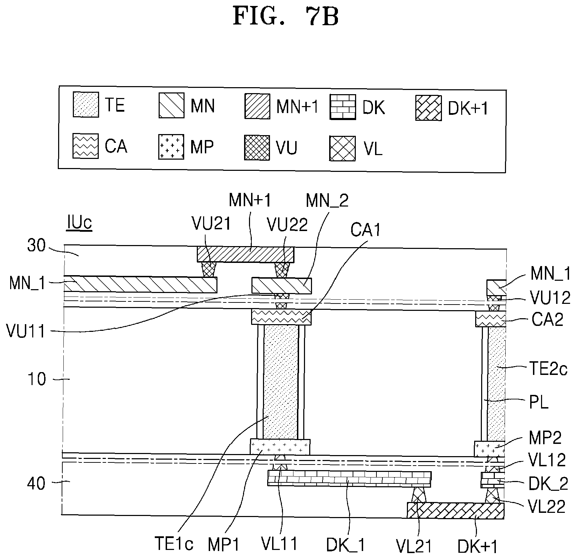

FIG. 7B is a cross-sectional view taken along the cutting line 7A-7A' in FIG. 7A. In more detail, FIG. 7B shows a portion IUc corresponding to one winding of the inductive element IDc. The portion IUc shown in FIG. 7B may be a unit inductor included in the inductive element IDc.

Referring to FIGS. 7A and 7B, the portion IUc of the inductive element IDc may include a first upper metallization pattern MN_1, a second upper via VU21, a second upper metallization pattern MN+1, a second upper via VU22, a first upper metallization pattern MN_2, a first upper via VU11, a first upper contact CA1, and a first through electrode. TE1c, a first lower contact MP1, a first lower via VL11, a first lower metallization pattern DK_1, a second lower via VL21, a second lower metallization pattern DK+1, a second lower via VL22, a first lower metallization pattern DK_2, a first lower via VL12, a second lower contact MP2, a second through electrode TE2c, a second upper contact CA2, and a first upper via VU12.

According to some embodiments, a current introduced through the first upper metallization pattern MN_1 of the inductive element IDc may sequentially flow through the second upper via VU21, the second upper metallization pattern MN+1_1, the second upper via VU22, the first upper metallization pattern MN_2, the first upper via VU11, the first upper contact CA1, the first through electrode TE1c, the first lower contact MP1, the lower via VL11, the first lower metallization pattern DK_1, the lower via VL12, the second lower contact MP2, the second through electrode TE2c, the second upper contact CA2, and the first upper via. VU12.

The inductive element IDc may have a structure in which portions IUc formed along the cutting line 7A-7A' are repeated. Both ends of each of the portions IUc of the inductive element IDc may be connected to a plurality of input/output wires I/O1, I/O2, I/O3, and I/O4 implemented on the first upper metallization pattern MN.

In some embodiments, the planar shapes (or horizontal cross-sectional shapes) of the first and second through electrodes TE1c and TE2c are similar to the planar shapes (or horizontal cross-sectional shapes) of the first and second through electrodes TE1b and TE2b described with reference to FIGS. 6A and 6B.

In this embodiment, the first and second through electrodes TE1c and TE2c have an island shape, and thus each of the portions IUc of the inductive element IDc may include a second upper metallization pattern MN+1 and a second lower metallization pattern DK+1 extending in the Y direction to form a winding in three dimensions. In this example, the first upper metallization pattern MN_2 may be a pad for the second upper metallization pattern MN+1, and the first lower metallization pattern DK_2 may be a pad for the second lower metallization pattern DK+1.

According to some embodiments, the first upper metallization pattern MN_1 and the first lower metallization pattern DK_1 overlapping each other in the Y direction are spaced apart in the Z direction with the first and second through electrodes TE1c and TE2c therebetween, and thus each of the parts IUc of the inductive element IDc may include a three-dimensionally wound structure.

A portion of the substrate 10 may be between the first through electrodes TE1c and the second through electrodes TE2c.

The first through electrodes TE1c may be aligned in the Y direction. The first through electrodes TE1c may be spaced apart from each other in the Y direction. The first through electrodes TE1c may be arranged in a row in the Y direction. A distance between each of the first through electrodes TE1c and the first guard ring GR1 may be greater than a distance between each of the first through electrodes TE1c and the second guard ring GR2. The first through electrodes TE1c may be spaced apart from the first guard ring GR1 with the second through electrodes TE2c therebetween.

The second through electrodes TE2c may be aligned in the Y direction. The second through electrodes TE2c may be spaced apart from each other in the Y direction. The second through electrodes TE2c may be arranged in a row in the Y direction. A distance between each of the second through electrodes TE2c and the second guard ring GR2 may be greater than a distance between each of the second through electrodes TE2c and the first guard ring GR1. The second through electrodes TE2c may be spaced apart from the second guard ring GR2 with the first through electrodes TE1c therebetween.

The first through electrodes TE1c may be spaced apart from the second through electrodes TE2c in the X direction. The first through electrodes TE1c may be alternately disposed with the second through electrodes TE2c. Each of the first through electrodes TE1c may not overlap each of the adjacent second through electrodes TE2c in the X direction. Each of the first through electrodes TE1c may be spaced apart from each of the adjacent second through electrodes TE2c in the Y direction.

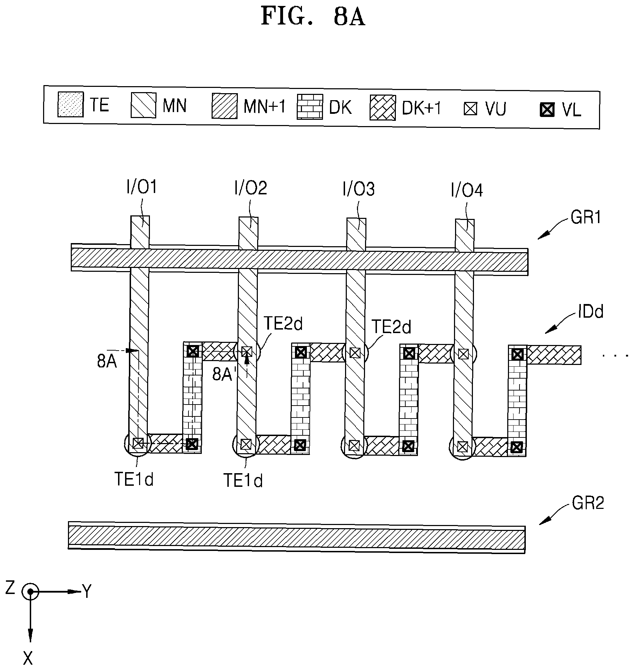

FIG. 8A is a diagram for explaining an inductive element IDd according to some other embodiments. In more detail, FIG. 8A shows a portion corresponding to FIG. 1B.

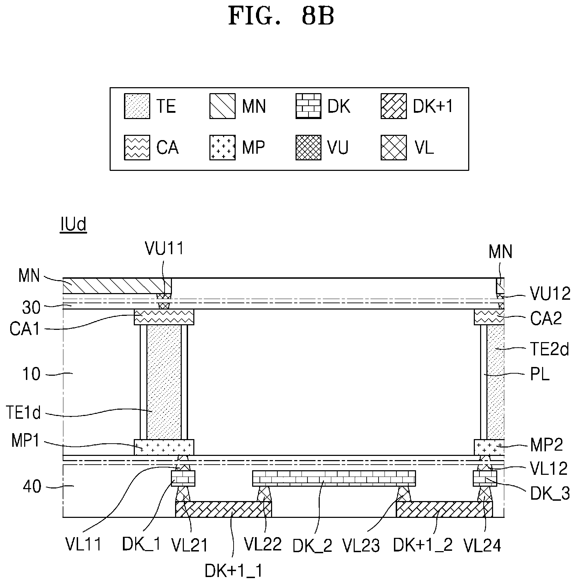

FIG. 8B is a cross-sectional view taken along the line 8A-8A' in FIG. 8A. In more detail, FIG. 8B shows a portion IUd corresponding to one winding of the inductive element IDd. The portions IUd shown in FIG. 8B may be a unit inductor included in the inductive element IDd.

Referring to FIGS. 8A and 8B, the portion IUd of the inductive element IDd may include a first upper metallization pattern MN, a first upper via VU11, a first upper contact CA1, a first through electrode TE1d, a first lower contact MP1, a first lower via VL11, a first lower metallization pattern DK_1, a second lower via VL21, a second lower metallization pattern DK+1_1, a second lower via VL22, a first lower metallization pattern DK_2, a second lower via VL23, a second lower metallization pattern DK+1_2, a second lower via VL24, a first lower metal a layer pattern DK_3, a first lower via VL12, a second lower contact MP2, a second through electrode TE2d, a second upper contact CA2, and a first upper via VU12.

According to some embodiments, a current introduced through the first upper metallization pattern MN of the inductive element IDd may sequentially flow through the first upper via VU11, the first upper contact CA1, the first through electrode TE1d, the first lower contact MP 1, the first lower via VL11, the first lower metallization pattern DK_1, the second lower via VL21, and the second lower metallization pattern DK+1_1, the second lower via VL22, the first lower metallization pattern DK_2, second lower via VL23, the second lower metallization pattern DK+1_2, the second lower via VL24, the first lower metal a layer pattern DK_3, the first lower via VL12, the second lower contact MP2, the second through electrode TE2d, the second upper contact CA2, and the first upper via VU12.

The inductive element IDd may have a structure in which portions IUd formed along the cutting line 8A-8A' are repeated. Both ends of each of the portions IUd of the inductive element IDd may be connected to a plurality of input/output wires I/O1, I/O2, I/O3, and I/O4 implemented on the first upper metallization pattern MN.

According to some embodiments, the planar shapes (or the shape of the horizontal section) of the first and second through electrodes TE1d and TE2d are similar to the planar shapes (or the shape of the horizontal section) of the first and second through electrodes TE1b and TE2b described with reference to FIGS. 6A and 6B.

In this embodiment, the first and second through electrodes TE1d and TE2d have an island shape, and thus each of the portions IUd of the inductive element IDd may include second lower metallization patterns DK+1_1 and DK+1_2 extending in the Y direction to form windings in three dimensions. In this example, the first lower metallization patterns DK_2 and DK_3 may be pads for the second lower metallization patterns DK+1_1 and DK+1_2.

According to some embodiments, the first upper metallization pattern MN_1 and the first lower metallization pattern DK_1 overlapping in the Y direction are spaced apart from each other in the Z direction with the first and second through electrodes TE1d and TE2d interposed therebetween, and thus each of the portions IUd of the inductive element IDd may include a three-dimensionally wound structure.

A portion of the substrate 10 may be between the first through electrodes TE1d and the second through electrodes TE2d.

The first through electrodes TE1d may be aligned in the Y direction. The first through electrodes TE1d may be spaced apart from each other in the Y direction. The first through electrodes TE1d may be arranged in a row in the Y direction. A distance between each of the first through electrodes TE1d and the first guard ring GR1 may be greater than a distance between each of the first through electrodes TE1d and the second guard ring GR2. The first through electrodes TE1d may be spaced apart from the first guard ring GR1 with the second through electrodes TE2d therebetween.

The second through electrodes TE2d may be aligned in the Y direction. The second through electrodes TE2d may be spaced apart from each other in the Y direction. The second through electrodes TE2d may be arranged in a row in the Y direction. A distance between each of the second through electrodes TE2d and the second guard ring GR2 may be greater than a distance between each of the second through electrodes TE2d and the first guard ring GR1. The second through electrodes TE2d may be spaced apart from the second guard ring GR2 with the first through electrodes TE1d therebetween.

The first through electrodes TE1d may be spaced apart from the second through electrodes TE2d in the X direction. At least some of the first through electrodes TE1d may be aligned with the second through electrodes TE2d in the X direction. At least some of the first through electrodes TE1d may overlap a corresponding one of the adjacent second through electrodes TE2d in the X direction.

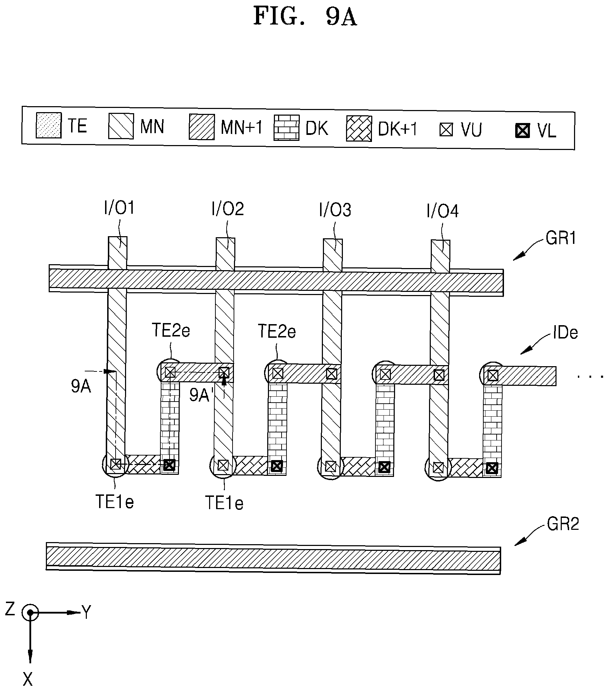

FIG. 9A is a diagram for explaining an inductive element IDe according to other embodiments. In more detail, FIG. 9A shows a portion corresponding to FIG. 1B.

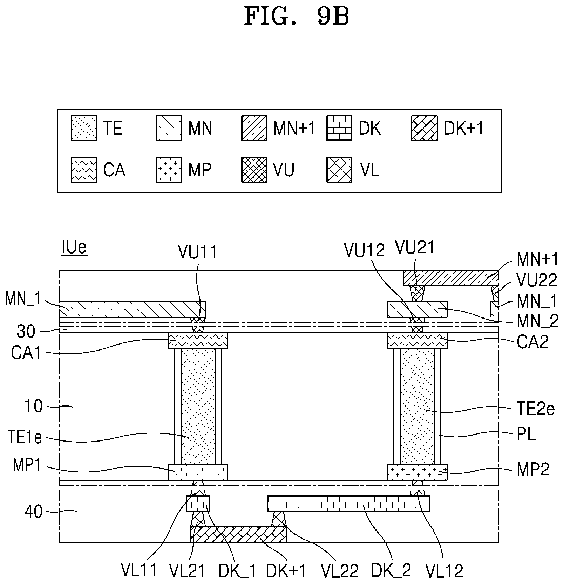

FIG. 9B is a cross-sectional view taken along the line 9A-9A' in FIG. 9A. In more detail, FIG. 9B shows a portion IUe corresponding to one winding of the inductive element IDe. The portion IUe shown in FIG. 9B may be a unit inductor included in the inductive element IDe.

Referring to FIG. 9A and 9B, the portion IUe of the inductive element IDe may include a first upper metallization pattern MN_1, a first upper via VL111, a first upper contact CA1, a first through electrode TE1e, a first lower contact MP1, a first lower via VL11, a first lower metallization pattern DK_1, a second lower via VL21, a second lower metallization pattern DK+1, a second lower via VL22, a first lower metallization pattern DK_2, a first lower via VL12, a second lower contact MP2, a second through electrode TE2e, a second upper contact CA2, a first upper via VU12, a first upper metallization pattern MN_2, a second upper via VU21, a second upper metallization pattern MN+1, and a second upper via VL122.

According to some embodiments, a current introduced through the first upper metallization pattern MN_1 of the inductive element ID sequentially flow through the first upper via VL111, the first upper contact CA1, the first through electrode TE1e, the first lower contact MP1, the first lower via VL11, the first lower metallization pattern DK_1, the second lower via VL21, the second lower metallization pattern DK+1, the second lower via VL22, the first lower metallization pattern DK_2, the first lower via VL12, the second lower contact MP2, the second through electrode TE2e, the second upper contact CA2, the first upper via VU12, the first upper metallization pattern MN_2, the second upper via VU21, the second upper metallization pattern MN+1, and the second upper via VL122.

The inductive element IDe may have a structure in which portions IUe formed along the cutting line 9A-9A' are repeated. Both ends of each of the portions IUe of the inductive element IDe may be connected to a plurality of input/output wires I/O1, I/O2, I/O3, and I/O4 implemented on the first upper metallization pattern MN.

According to some embodiments, the planar shapes (or horizontal cross-sectional shapes) of the first and second through electrodes TE1e and TE2e are similar to the planar shapes (or horizontal cross-sectional shapes) of the first and second through electrodes TE1b and TE2b described with reference to FIGS. 6A and 6B.

In this embodiment, the first and second through electrodes TE1e and TE2e have an island shape, and thus each of the portions IUe of the inductive element IDe may include a second upper metallization pattern MN+1 and a second lower metallization pattern DK+1 extending in the Y direction to form windings in three dimensions. In this example, the first upper metallization pattern MN_2 may be a pad for the second upper metallization pattern MN+1, and the first lower metallization pattern DK_2 may be a pad for the second lower metallization pattern DK+1.

According to some embodiments, the first upper metallization pattern MN_1 and the first lower metallization pattern DK_1 overlapping in the Y direction are spaced apart from each other in the Z direction with the first and second through electrodes TE1e and TE2e interposed therebetween, and thus each of the portions IUe of the inductive element IDe may include a three-dimensionally wound structure.

A portion of the substrate 10 may be between the first through electrodes TE1e and the second through electrodes TE2e.

The first through electrodes TE1e may be aligned in the Y direction. The first through electrodes TE1e may be spaced apart from each other in the Y direction. The first through electrodes TE1e may be arranged in a row in the Y direction. A distance between each of the first through electrodes TE1e and the first guard ring GR1 may be greater than a distance between each of the first through electrodes TE1e and the second guard ring GR2. The first through electrodes TE1e may be spaced apart from the first guard ring GR1 with the second through electrodes TE2e therebetween.

The second through electrodes TE2e may be aligned in the Y direction. The second through electrodes TE2e may be spaced apart from each other in the Y direction. The second through electrodes TE2e may be arranged in a line in the Y direction. A distance between each of the second through electrodes TE2e and the second guard ring GR2 may be greater than a distance between each of the second through electrodes TE2e and the first guard ring GR1. The second through electrodes TE2e may be spaced apart from the second guard ring GR2 with the first through electrodes TE1e therebetween.

The first through electrodes TE1e may be spaced apart from the second through electrodes TE2e in the X direction. The first through electrodes TE1e may be alternately disposed with the second through electrodes TE2e. Each of the first through electrodes TE1e may not overlap each of the adjacent second through electrodes TE2e in the X direction. Each of the first through electrodes TE1e may be spaced apart from each of the adjacent second through electrodes TE2e in the Y direction.

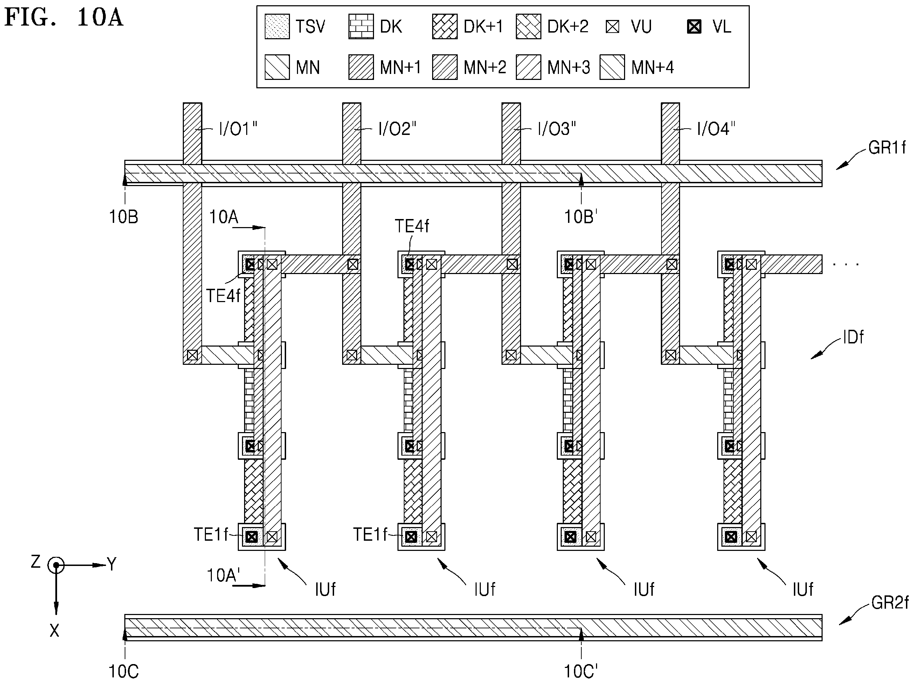

FIG. 10A is a diagram for explaining an inductive element IDf, a first guard ring GR1f, and a second guard ring GR2f according to some other embodiments. In more detail, FIG. 10A shows a portion corresponding to FIG. 1B.

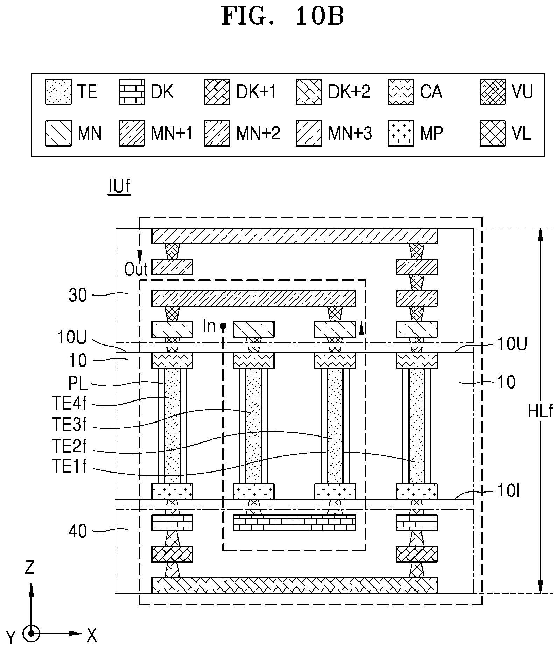

FIG. 10B is a cross-sectional view taken along the line 10A-10A' in FIG. 10A.

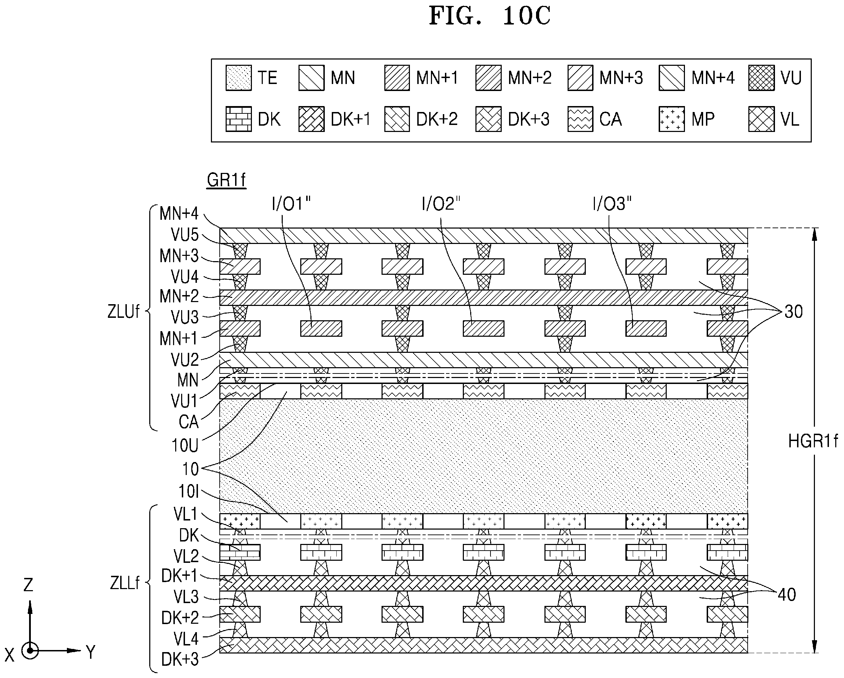

FIG. 10C is a cross-sectional view taken along the line 10B-10B' in FIG. 10A.

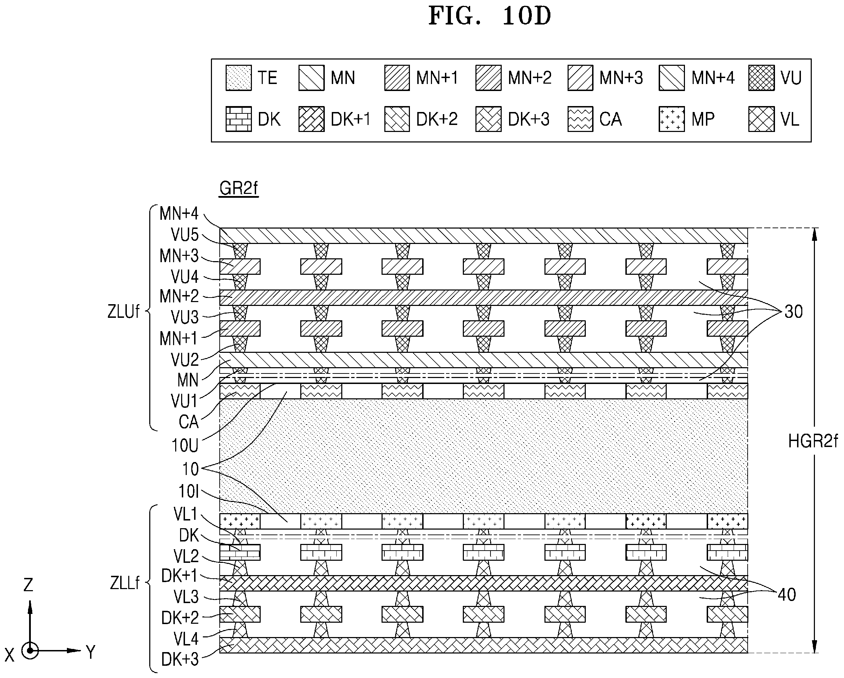

FIG. 10D is a cross-sectional view taken along the line 10C-10C' in FIG. 10A.

Referring to FIG. 10A and 10B, the inductive element IDf may include first through fourth through electrodes TE1f, TE2f, TE3f, and TE4f.

The first through fourth through electrodes TE1f, TE2f, TE3f, and TE4f may be spaced apart from each other in the X direction. The first to fourth through electrodes TE1f, TE2f, TE3f, and TE4f may be aligned in the X direction. The first through fourth through electrodes TE1f, TE2f, TE3f, and TE4f may overlap each other in the X direction.

The first through electrodes TE1f may be adjacent to the second guard ring GR2f. The fourth through electrodes TE4f may be adjacent to the first guard ring GR1f. The first through electrodes TE1f may be between the fourth through electrodes TE4f and the second guard ring GR2f. The fourth through electrodes TE4f may be between the first through electrodes TE1f and the first guard ring GR1f. The second through electrodes TE2f may be between the first through electrodes TE1f and the fourth through electrodes TE4f. The third through electrodes TE3f may be between the second through electrodes TE2f and the fourth through electrodes TE4f.

A planar shape of each of the first to fourth through electrodes TE1f, TE2f, TE3f, and TE4f may be a rod extending in the Y direction, but is not limited thereto. A planar shape of each of the first through fourth through electrodes TE1f, TE2f, TE3f, and TE4f may be circular.

The first through electrodes TE1f may be spaced apart from each other in the Y direction. The first through electrodes TE1f may be aligned in the Y direction. The first through electrodes TE1f may overlap each other in the Y direction.

The second through electrodes TE2f may be spaced apart from each other in the Y direction. The second through electrodes TE2f may be aligned in the Y direction. The second through electrodes TE2f may overlap each other in the Y direction.

The third through electrodes TE3f may be spaced apart from each other in the Y direction. The third through electrodes TE3f may be aligned in the Y direction. The third through electrodes TE3f may be aligned in the Y direction.

The fourth through electrodes TE4f may be spaced apart from each other in the Y direction. The fourth through electrodes TE4f may be spaced apart from each other in the Y direction. The fourth through electrodes TE4f may overlap each other in the Y direction.

Unlike the inductive element ID shown in FIG. 1B, the inductive element IDf may be designed based on the first to fourth through electrodes TElf, TE2f, TE3f, and TE4f of the four tracks. A winding axis of the inductive element IDf may be parallel to the Y direction.

According to some embodiments, as shown in FIG. 10B, the inductive element IDf may include a portion IUf that is spirally wound a plurality of times on a plane (i.e., ZX plane) perpendicular to the direction of the winding axis (i.e., the Y direction). The portion IUf shown in FIG. 10B may be a unit inductor included in the inductive element IDf.

The second and third through electrodes TE2f and TE3f, the second upper metallization pattern MN+1 connected to the second and third through electrodes TE2f and TE3f, and the first lower metallization pattern DK connected to the second and third through electrodes TE2f and TE3f may constitute a first winding. First and fourth through electrodes TE1f and TE4f, a fourth upper metallization pattern MN+3 connected to the first and fourth through electrodes TE1f and TE4f, and a third lower metallization pattern DK+2 connected to the first and fourth through electrodes TE1f and TE4f may constitute a second winding defining a larger cross-sectional area than a first winding. Portion IUf may include first and second windings.

According to some embodiments, a length of the second upper metallization pattern MN+1 of the portion IUf in the X direction may be shorter than a length of the fourth upper metallization pattern MN+3 of the portion IUf in the X direction. The second upper metallization pattern MN+1 may be between the fourth upper metallization pattern MN+3 and the upper surface 10U of the substrate 10.

According to some embodiments, a length of the first lower metallization pattern DK of portion IUf in the X direction may be shorter than a length of third lower metallization pattern DK+2 of portion IUf in the X direction. The first lower metallization pattern DK may be between the third lower metallization pattern DK+2 and the inactive surface 10I of the substrate 10.

The inductive element IDf may include a plurality of portions IUf. The inductive element IDf may include a structure in which portions IUf shown in cutting line 10A-10A' are repeated in the Y direction. The portions IUf may be connected to each other through the first to third upper metallization patterns MN, MN+1, and MN+2 between the portions IUf.

Both ends of each of the portions IUf of the inductive element IDf may be connected to input/output wires I/O1", I/O2", I/O3", and I/O4" implemented as the second upper metallization pattern MN+1. Each of the portions IUf of the inductive element IDf may be a portion interposed between the input/output wires I/O1", I/O2", I/O3", and I/O4". By selecting two of the input/output wires I/O1", I/O2", I/O3", I/O4", the size and position of the inductance of the inductive element IDf between the selected plurality of input/output wires I/O1", I/O2", I/O3", and I/O4" may be determined.

In FIG. 10B, the dashed arrow indicates the winding direction of portion IUf (or the direction of current that may flow along portion IUf). In FIG. 10B, a counterclockwise wound portion (lUf) is shown, but one skilled in the art will readily be able to arrive at an inductive element including clockwise wound portions based on what has been described herein.

In addition, a person skilled in the art may easily arrive at an inductive element including a portion of an N-turned helical structure including 2xN (where N is an integer) through electrodes, based on the description of the portion (IUt) of a twice-wound helical structure including four through electrodes (i.e., first through fourth through electrodes TE1f, TE2f, TE3f, and TE4f) aligned in the X direction. In this case, the number of layers of the upper metallization pattern and the number of layers of the lower metallization pattern constituting the portion IUf may also increase.

In addition, a person skilled in the art may easily arrive at an inductive element including a portion including 3 layers of upper metallization patterns (that is, the first to third lower metallization patterns DK, DK+1, and DK+2) and 4 layers of lower metallization patterns (that is, the first to fourth upper metallization patterns MN, MN+1, MN+2, and MN+3), based on the portion IUf including 4 layers of upper metallization patterns and 3 layers of lower metallization patterns.

Referring to FIGS. 10A to 10D, the first and second guard rings GR1f and GR2f may extend in the Y direction. A length of each of the first and second guard rings GR1f and GR2f in the Y direction may be greater than or equal to the length of the inductive element IDf in the Y direction. The first and second guard rings GR1f and GR2f may horizontally surround the inductive element IDf. The inductive element IDf may overlap each of the first and second guard rings GR1f and GR2f in the X direction over the entire extending direction.

Each of the first height HGR1F of the first guard ring GR1F and the second height HGR2f of the second guard ring GR2f may be equal to or greater than the height HLf of the inductive element IDf. For example, when the uppermost element of the inductive element IDf is the fourth upper metallization pattern MN+3 and the lowermost element of the inductive element is the third lower metallization pattern DK+2, the first and second guard rings GR1f and GR2f may include a fourth upper metallization pattern MN+3, a third lower metallization pattern DK+2, and conductive elements therebetween (a fourth upper via VU4, a third upper metallization pattern MN+2, a third upper via VU3, a second upper metallization pattern MN+1, a second upper via VU2, a first upper metallization pattern MN, a first upper via VU, an upper contact CA, a through electrode TE, a lower contact MP, a first lower via VL1, a first lower metallization pattern DK, a second lower via VL2, a second lower metallization pattern DK+1, and a third lower via VL3).

According to some embodiments, first and second guard rings GR1f and GR2f may further include a fifth upper metallization pattern MN+4 farther from the substrate 10 (e.g., the upper surface 10U ) than the fourth upper metallization pattern MN+3 that is an uppermost element of the inductive element IDf. The first and second guard rings GR1f and GR2f may include a fourth lower metallization pattern DK+3 farther from the substrate 10 (e.g., inactive surface 10I) than the third lower metallization pattern DK+2 that is a lowermost element of the inductive element IDf.

The first and second guard rings GR1f and GR2f may include a mesh structure. Each of the second and fourth upper metallization patterns MN+1 and MN+3 and the first and third lower metallization patterns DK and DK+2 included in the first and second guard rings GR1f and GR2f may have an island shape.

Sequentially stacked upper contacts CA, first upper vias VU1, portions of the first upper metallization pattern MN, second upper vias VU2, island-shaped second upper metallization patterns MN+1, third upper vias VU3, portions of the third upper metallization pattern MN+2, fourth upper vias VU, island-shaped fourth upper metallization patterns MN+3, fifth upper vias VU5, and portions of the fifth upper metallization pattern MN+4, of each of the first and second guard rings GR1f and GR2f may constitute a plurality of upper Z lines ZLUf extending in the Z direction.

Each of the first, third, and fifth upper metallization patterns MN, MN+2, and MN+4 of each of the first and second guard rings GR1f and GR2f may have a line shape extending in the Y direction. The first, third, and fifth upper metallization patterns MN, MN+2, and MN+4 may be sequentially referred to as first to third upper Y lines, respectively. The first, third, and fifth upper metallization patterns MN, MN+2, and MN+4, the plurality of upper Z lines ZLUf, and the through electrode TE may together constitute a mesh structure.

Sequentially stacked lower contacts MP, first lower vias VL1, island-shaped first lower metallization patterns DK, second lower vias VL2, portions of a second lower metallization pattern DK+1, third lower vias VL3, island-shaped third lower metallization patterns DK+2, a fourth lower via VL4, and portions of a fourth lower metallization pattern DK+3, of each of the first and second guard rings GR1f and GR2f may constitute a plurality of lower Z lines ZLLf extending in the Z direction.

The second and fourth lower metallization patterns DK+1 and DK+3 of each of the first and second guard rings GR1f and GR2f may have a line shape extending in the Y direction. The second and fourth lower metallization patterns DK+1 and DK+3 of each of the first and second guard rings GR1f and GR2f may be referred to as first and second lower Y lines, respectively, in order. The second and fourth lower metallization patterns DK+1 and DK+3, the plurality of lower Z lines ZLL, and the through electrode TE may constitute the aforementioned mesh structure.

According to some embodiments, each of the plurality of input/output wires I/O1", I/O2", I/O3", and I/O4" may pass through the first guard ring GR1 to extend in the X direction toward the active region AR (refer to FIG. 1A). Each of the plurality of input/output wires I/O1", I/O2", I/O3", and I/O4" may be surrounded by first upper metallization patterns MN, a plurality of upper Z lines ZLU, and fourth upper metallization patterns MN+2.

Each of the plurality of input/output wires I/O1", I/O2", I/O3", and I/O4" may be spaced apart from the first upper metallization patterns MN, the plurality of upper Z lines ZLU, and the fourth upper metallization patterns MN+2. Each of the plurality of input/output wires I/O1", I/O2", I/O3", and I/O4" may contact a portion of the upper insulating layer 30 surrounded by the first upper metallization patterns MN, a plurality of upper Z lines ZLU, and fourth upper metallization patterns MN+2. Each of the plurality of input/output wires I/O1", I/O2", I/O3", and I/O4" may be insulated from the first upper metallization patterns MN by the upper insulating layer 30, a plurality of upper Z lines ZLU, and fourth upper metallization patterns MN+2.

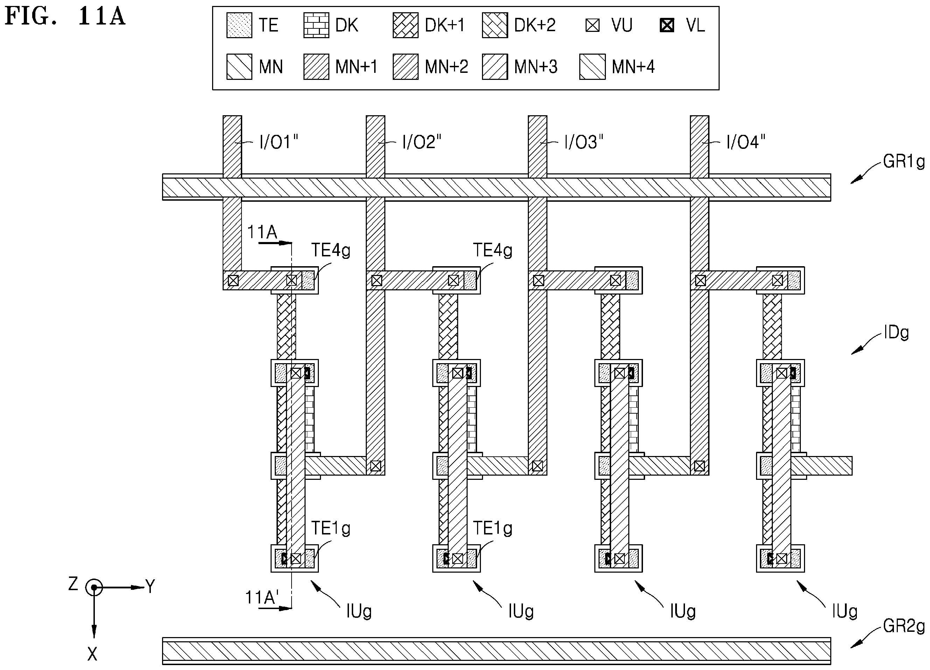

FIG. 11A is a diagram for explaining an inductive element IDg, a first guard ring GR1g, and a second guard ring GR2g according to some other embodiments. In more detail, FIG. 11A shows a portion corresponding to FIG. 1B.

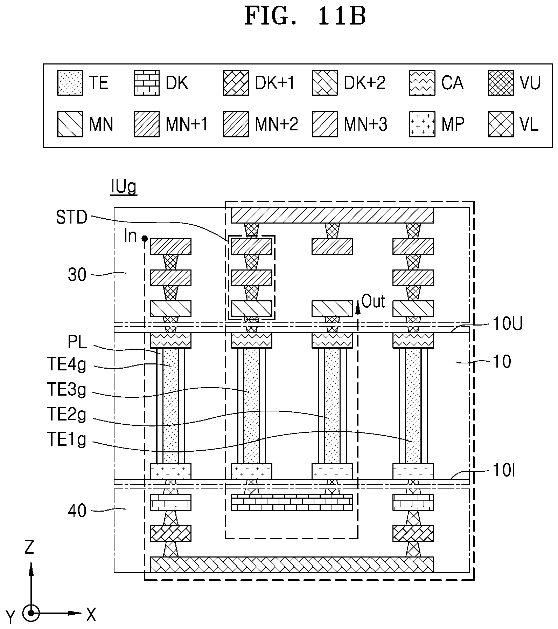

Fig. 11B is a cross-sectional view taken along the line 11A-11A' in Fig. 11A.

Referring to FIG. 11A and 11B, the inductive element IDg may include first through fourth through electrodes TE1g, TE2g, TE3g, and TE4g.

The first to fourth through electrodes TE1g, TE2g, TE3g, and TE4g may be spaced apart from each other in the X direction. The first to fourth through electrodes TE1g, TE2g, TE3g, and TE4g may be aligned in the X direction. The first to fourth through electrodes TE1g, TE2g, TE3g, and TE4g may overlap each other in the X direction.

The first through electrodes TE1g may be adjacent to the second guard ring GR2g. The fourth through electrodes TE4g may be adjacent to the first guard ring GR1g. The first through electrodes TE1g may be between the fourth through electrodes TE4g and the second guard ring GR2g. The fourth through electrodes TE4g may be between the first through electrodes TE1g and the first guard ring GR1g. The second through electrodes TE2g may be between the first through electrodes TE1g and the fourth through electrodes TE4g. The third through electrodes TE3g may be between the second through electrodes TE2g and the fourth through electrodes TE4g.

A planar shape of each of the first to fourth through electrodes TE1g, TE2g, TE3g, and TE4g may be a rod extending in the Y direction, but is not limited thereto. A planar shape of each of the first to fourth through electrodes TE1g, TE2g, TE3g, and TE4g may be circular.

The first through electrodes TE1g may be spaced apart from each other in the Y direction. The first through electrodes TE1g may be aligned in the Y direction. The first through electrodes TE1g may overlap each other in the Y direction.

The second through electrodes TE2g may be spaced apart from each other in the Y direction. The second through electrodes TE2g may be aligned in the Y direction. The second through electrodes TE2g may overlap each other in the Y direction.

The third through electrodes TE3g may be spaced apart from each other in the Y direction. The third through electrodes TE3g may be aligned in the Y direction. The third through electrodes TE3g may overlap each other in the Y direction.

The fourth through electrodes TE4g may be spaced apart from each other in the Y direction. The fourth through electrodes TE4g may be aligned in the Y direction. The fourth through electrodes TE4g may overlap each other in the Y direction.

Similar to the inductive element IDf shown in FIGS. 10A and 10B, the inductive element IDg may be designed based on the first through fourth through electrodes TE1g, TE2g, TE3g, and TE4g of the four tracks. A winding axis of the inductive element IDg may be parallel to the Y direction.

The second and third through electrodes TE2g and TE3g, the second upper metallization pattern MN+1 connected to the second and third through electrodes TE2g and TE3g, and the first lower metallization pattern DK connected to the third through electrodes TE2g and TE3g may constitute a first winding. The first and fourth through electrodes TE1g and TE4g, the fourth upper metallization pattern MN+3 connected to the first and fourth through electrodes TE1g and TE4g, and a third lower metallization pattern DK+2 connected to the third through electrodes TE2g and TE3g may constitute a second winding defining a larger cross-sectional area than the first winding. Each of the portions IUg may include first and second windings. Each of the portions IUg shown in FIG. 11B may be a unit inductor included in the inductive element IDg.

Between the first winding and the second winding, a stud structure STD connecting the first winding and the second winding may be interposed. The stud structure STD may connect the third through electrode TE3g to the fourth upper metallization pattern MN+3. The stud structure STD may vertically overlap the third through electrode TE3g. The stud structure STD may include island-shaped first to third upper metallization patterns MN, MN+1, and MN+2 and upper vias VU therebetween.

The inductive element IDg may include a plurality of portions IUg. The inductive element IDg may include a structure in which portions IUg shown in cutting line 11A-11A' are repeated in the Y direction. The portions IUg may be connected to each other through the first to third upper metallization patterns MN, MN+1, and MN+2 between the portions IUg.

According to some embodiments, as shown in FIG. 11B, the inductive element IDg may include portions IUg that are spirally wound a plurality of times on a plane (i.e., ZX plane) perpendicular to the direction of the winding axis (i.e., the Y direction). Unlike the inductive element IDf shown in FIGS. 10A and 10B including portions IUf including spiral structures wound in a direction in which the radius increases (e.g., in which a winding radius increases), the inductive element IDg may include portions IUg including a spiral structure wound in a direction in which the radius decreases (e.g., in which a winding radius decreases).

Both ends of each of the portions IUg of the inductive element IDg may be connected to input/output wires I/O1", I/O2", I/O3", and I/O4" implemented on the second upper metallization pattern MN+1.

Because the first guard ring GR1g and the second guard ring GR2g are substantially the same as the first and second guard rings GR1f and GR2f of FIG. 10A, descriptions already given thereto are omitted.

In FIG. 11B, dashed line arrows indicate winding directions of portions IUg (or directions of currents that may flow along portions IUg). In FIG. 11B, counter-clockwise wound portions (IUg) are shown, but one skilled in the art may easily arrive at an inductive element that includes clockwise wound portions based on what has been described herein.

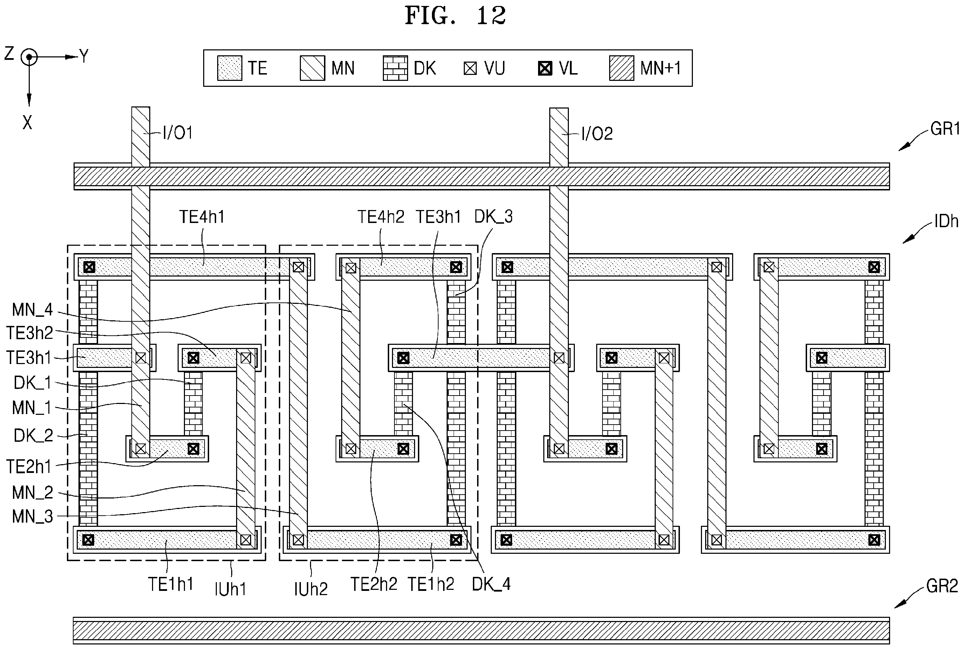

FIG. 12 is a diagram for explaining an inductive element IDh according to some other embodiments. In more detail, FIG. 12 shows a portion corresponding to FIG. 1B.

Referring to FIG. 12, the inductive element IDh may include first through electrodes TE1h1 and TE 1 h2, second through electrodes TE2h1 and TE2h2, third through electrodes TE3h1 and TE3h2, and fourth through electrodes TE4h1 and TE4h2.

The first through electrodes TE1h1 and TE1h2 may be adjacent to the second guard ring GR2. The fourth through electrodes TE4h1 and TE4h2 may be adjacent to the first guard ring GR1. The first through electrodes TE1h1 and TE1h2 may be between the fourth through electrodes TE4h1 and Te4h2 and the second guard ring GR2. The fourth through electrodes TE4h1 and TE4h2 may be between the first through electrodes TE1h1 and TE1h2 and the first guard ring GR1. The second through electrodes TE2h1 and TE2h2 may be between the first through electrodes TE1h1 and TE1h2 and the fourth through electrodes TE4h1 and TE4h2. The third through electrodes TE3h1 and TE3h2 may be between the second through electrodes TE2h1 and TE2h2 and the fourth through electrodes TE4h1 and TE4h2.

The first through electrodes TE1h1 and TE1h2 may extend in the Y direction. The first through electrodes TE1h1 and TE1h2 may be spaced apart from each other in the Y direction. The first through electrodes TE1h1 and TE1h2 may be aligned in the Y direction. The first through electrodes TE1h1 and TE1h2 may overlap each other in the Y direction. The first through electrodes TE1h1 and the first through electrodes TE1h2 may be alternately arranged.

The second through electrodes TE2h1 and TE2h2 may extend in the Y direction. The second through electrodes TE2h1 and TE2h2 may be spaced apart from each other in the Y direction. The second through electrodes TE2h1 and TE2h2 may be aligned in the Y direction. The second through electrodes TE2h1 and TE2h2 may overlap each other in the Y direction. The second through electrodes TE2h1 and the second through electrodes TE2h2 may be alternately arranged.

The third through electrodes TE3h1 and TE3h2 may extend in the Y direction. The third through electrodes TE3h1 and TE3h2 may be spaced apart from each other in the Y direction. The third through electrodes TE3h1 and TE3h2 may be aligned in the Y direction. The third through electrodes TE3h1 and TE3h2 may overlap each other in the Y direction. The third through electrodes TE3h1 and the third through electrodes TE3h2 may be alternately arranged.

The fourth through electrodes TE4h1 and TE4h2 may extend in the Y direction. The fourth through electrodes TE4h1 and TE4h2 may be spaced apart from each other in the Y direction. The fourth through electrodes TE4h1 and TE4h2 may be aligned in the Y direction. The fourth through electrodes TE4h1 and TE4h2 may overlap each other in the Y direction. The fourth through electrodes TE4h1 and the fourth through electrodes TE4h2 may be alternately arranged.

Each of the first through electrodes TE1h1 may overlap the second through electrodes TE2h1, a portion of the third through electrodes TE3h1, the third through electrode TE3h2, and a portion of the fourth through electrode TE4h1 in the X direction.

Each of the first through electrodes TE1h2 may overlap the second through electrode TE2h2, a portion of the third through electrode TE3h1, a portion of the fourth through electrode TE4h1, and the fourth through electrode TE4h2 in the X direction.

Each of the second through electrodes TE2h1 may overlap a portion of the third through electrode TE3h1, a portion of the third through electrode TE3h2, and a portion of the fourth through electrode TE4h1 in the X direction.

Each of the second through electrodes TE2h2 may overlap a portion of the third through electrodes TE3h1 and a portion of the fourth through electrode TE4h2 in the X direction.

Each of the third through electrodes TE3h1 may overlap a portion of the second through electrodes TE2h1 and a portion of the second through electrodes TE2h2, and a portion of the fourth through electrode TE4h1, and a portion of the fourth through electrode TE4h2 in the X direction, respectively.

Each of the third through electrodes TE3h2 may overlap a portion of the first through electrode TE1h1, a portion of the second through electrode TE2h1, and a portion of the fourth through electrode TE4h1 in the X direction.

The inductive element IDh may further include first upper metallization patterns MN_1, MN_2, MN_3, and MN_4 and first lower metallization patterns DK_1, DK_2, DK_3, and DK_4. The first upper metallization patterns MN_1, MN_2, MN_3, and MN_4 may extend in the X direction. The first lower metallization patterns DK_1, DK_2, DK_3, and DK_4 may extend in the X direction.

The first upper metallization pattern MN_1, the first upper metallization pattern MN_2, the first upper metallization pattern MN_3, and the first upper metallization pattern MN_4 may be arranged in the listed order in the Y direction. The first lower metallization pattern DK_2, the first lower metallization pattern DK_1, the first lower metallization pattern DK_4, and the first lower metallization pattern DK_3 may be arranged in the listed order in the Y direction.

The first through electrode TE1h1, the second through electrode TE2h1, a portion of the third through electrode TE3h1, the third through electrode TE3h2, a portion of the fourth through electrode TE4h1, the first upper metallization patterns MN_1 and MN_2, and the first lower metallization patterns DK_1 and DK_2 may constitute first portions IUh1 of the inductive element IDh.

The first upper metallization pattern MN_1 may be connected to each of the third through electrode TE3h1 and the second through electrode TE2h1. The first lower metallization pattern DK_1 may be connected to each of the second through electrode TE2h1 and the third through electrode TE3h2. The first upper metallization pattern MN_2 may be connected to each of the third through electrode TE3h2 and the first through electrode TE1h1. The first lower metallization pattern DK_2 may be connected to each of the first through electrode TE1h1 and the fourth through electrode TE4h1.

The third through electrode TE3h1, the first upper metallization pattern MN_1, the second through electrode TE2h1, the first lower metallization pattern DK_1, the third through electrode TE3h2, the first upper metallization pattern MN_2, the first through electrode TE1h1, the first lower metallization pattern DK_2, and the fourth through electrode TE4h1 may form a three-dimensionally wound structure. Each of the first portions IUh1 of the inductive element IDh may be wound in a direction in which a winding radius is widened or increases.

Accordingly, the current introduced through the third through electrode TE3h1 (or current introduced through the first upper metallization pattern MN_1 along I/O1) may flow through the first upper metallization pattern MN_1, the second through electrode TE2h1, the first lower metallization pattern DK_1, the third through electrode TE3h2, a first upper metallization pattern MN_2, a first through electrode TE1h1, a first lower metallization pattern DK_2, and a fourth through electrode TE4h1 in sequence.

The first through electrode TE1h2, the second through electrode TE2h2, a portion of the third through electrode TE3h1, a portion of the fourth through electrode TE4h1, the fourth through electrode TE4h2, first upper metallization pattern MN_3, and first lower metallization patterns DK_3 and DK_4 may constitute the second portions IUh2 of the inductive element IDh.

The first upper metallization pattern MN_3 may be connected to each of the fourth through electrode TE4h1 and the first through electrode TE1h2. The first lower metallization pattern DK_3 may be connected to each of the first through electrode TE1h2 and the fourth through electrode TE4h2. The first upper metallization pattern MN_4 may be connected to each of the fourth through electrode TE4h2 and the second through electrode TE2h2. The first lower metallization pattern DK_4 may be connected to each of the second through electrode TE2h2 and the third through electrode TE3h1.

The fourth through electrode TE4h1, the first upper metallization pattern MN_3, the first through electrode TE1h2, the first lower metallization pattern DK_3, the fourth through electrode TE4h2, and the first upper metallization pattern MN_4, the second through electrode TE2h2, the first lower metallization pattern DK_4, and the third through electrode TE3h1 may form a three-dimensionally wound structure. Each of the second portions IUh2 of the inductive element IDh may be wound in a direction in which a winding radius becomes narrow or decreases.

Accordingly, the current introduced through the fourth through electrode TE4h1 may sequentially flow through the first upper metallization pattern MN_3, the first through electrode TE1h2, the first lower metallization pattern DK_3, the fourth through electrode TE4h2, the first upper metallization pattern MN_4, the second through electrode TE2h2, the first lower metallization pattern DK_4, and the third through electrode TE3h1.

The first portions IUh1 and the second portions IUh2 of the inductive element IDh may be alternately and repeatedly arranged along the winding axis direction (i.e., the Y direction). The first portions IUh1 of the winding element may be connected to the input/output wires I/O1 and I/O2.

A person skilled in the art may easily know from the above-described connection relationship that the magnetic fluxes induced by the first portions IUh1 and the second portions IUh2 are directed in the same direction. Accordingly, magnetic flux by the first portions IUh1 and magnetic flux by the second portions IUh2 may be reinforced.

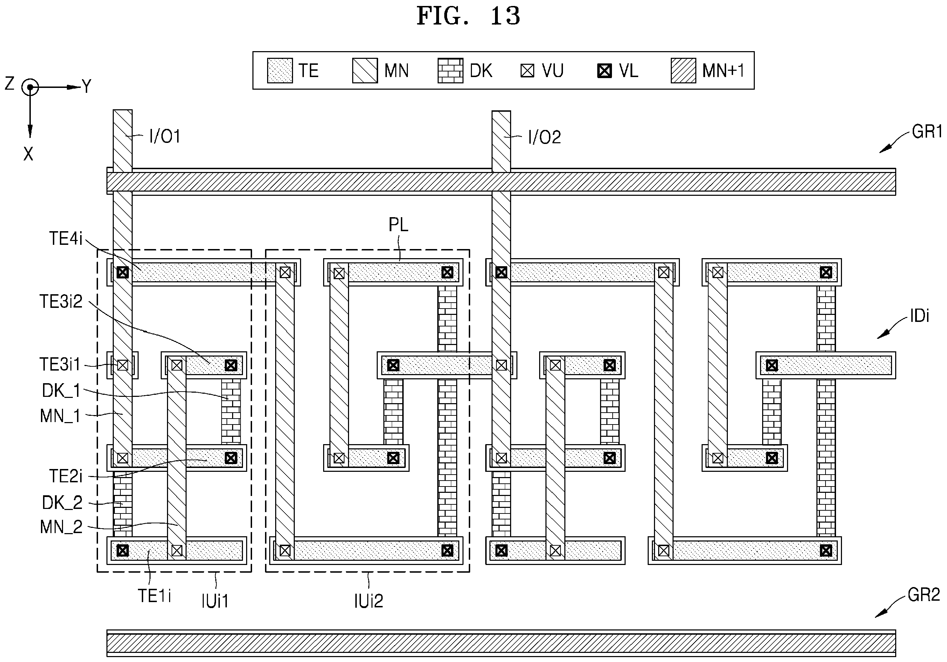

FIG. 13 is a diagram for explaining an inductive element IDi according to some other embodiments. In more detail, FIG. 13 shows a portion corresponding to FIG. 1B.

Referring to FIG. 13, the inductive element IDi may include first portions IUi1 and second portions IUi2 that are alternately and repeatedly disposed. In this case, because each of the second portions IUi2 is substantially the same as the second portions IUh2 of FIG. 12, a description already given thereto is omitted.

Each of the first portions IUi1 of the inductive element IDi may include a first through electrode TE1i, a second through electrode TE2i, third through electrodes TE3i1 and TE3i2, and a fourth through electrode TE4i.

The first through electrodes TE1i may be adjacent to the second guard ring GR2. The fourth through electrodes TE4i may be adjacent to the first guard ring GR1. The first through electrodes TE1i may be between the fourth through electrodes TE4i and the second guard ring GR2. The fourth through electrodes TE4i may be between the first through electrodes TE1i and the first guard ring GR1. The second through electrodes TE2i may be between the first through electrodes TE1i and the fourth through electrodes TE4i. The third through electrodes TE3i1 may be between the second through electrodes TE2i and the fourth through electrodes TE4i.

The first through electrodes TE1i may extend in the Y direction. The first through electrodes TE1i may be spaced apart from each other in the Y direction. The first through electrodes TE1i may be aligned in the Y direction. The first through electrodes TE1i may overlap each other in the Y direction.

The second through electrodes TE2i may extend in the Y direction. The second through electrodes TE2i may be spaced apart from each other in the Y direction. The second through electrodes TE2i may be aligned in the Y direction. The second through electrodes TE2i may overlap each other in the Y direction. The second through electrodes TE2i1 and the second through electrodes TE2i2 may be alternately arranged.

The third through electrodes TE3i1 and TE3i2 may extend in the Y direction. The third through electrodes TE3i1 and TE3i2 may be spaced apart from each other in the Y direction. The third through electrodes TE3i1 and TE3i2 may be aligned in the Y direction. The third through electrodes TE3i1 and TE3i2 may overlap each other in the Y direction. The third through electrodes TE3i1 and the third through electrodes TE3i2 may be alternately arranged.

The fourth through electrodes TE4i may extend in the Y direction. The fourth through electrodes TE4i may be spaced apart from each other in the Y direction. The fourth through electrodes TE4i may be aligned in the Y direction. The fourth through electrodes TE4i may overlap each other in the Y direction.

Each of the first through electrodes TE1i may overlap the second through electrode TE2i1, a portion of the third through electrode TE3i1, the third through electrode TE3i2, and a portion of the fourth through electrode TE4i1 in the X direction.

Each of the second through electrodes TE2i may overlap a portion of the third through electrode TE3i1, the third through electrode TE3i2, and a portion of the fourth through electrode TE4i1 in the X direction.

Each of the third through electrodes TE3i1 may overlap a portion of the second through electrodes TE2i in the X direction.

Each of the third through electrodes TE3i2 may overlap a portion of the first through electrode TE1i1, a portion of the second through electrode TE2i 1, and a portion of the fourth through electrode TE4i in the X direction.

The inductive element IDi may further include first upper metallization patterns MN_1 and MN_2 and first lower metallization patterns DK_1 and DK_2. The first upper metallization patterns MN_1 and MN_2 may extend in the X direction. The first lower metallization patterns DK_1 and DK_2 may extend in the X direction.

The first upper metallization pattern MN_1 may be connected to each of the third through electrode TE3i1 and the second through electrode TE2i. The first lower metallization pattern DK_1 may be connected to each of the second through electrode TE2i and the third through electrode TE3i2. The first upper metallization pattern MN_2 may be connected to each of the third through electrode TE3i2 and the first through electrode TE1i. The first lower metallization pattern DK_2 may be connected to each of the first through electrode TE1i and the fourth through electrode TE4i.

The third through electrode TE3i1, the first upper metallization pattern MN_1, the second through electrode TE2i, the first lower metallization pattern DK_1, the third through electrode TE3i2, the first upper metallization pattern MN_2, the first through electrode TE1i, the first lower metallization pattern DK_2, and the fourth through electrode TE4i may form a three-dimensionally wound structure. Each of the first portions IUi1 of the inductive element IDi may be wound in a direction in which a winding radius is widened or increase.

Accordingly, the current introduced through the third through electrode TE3i1 (or current introduced through the first upper metallization pattern MN_1 along I/O1) may flow through the first upper metallization pattern MN_1, the second through electrode TE2i, the first lower metallization pattern DK_1, the third through electrode TE3i2, a first upper metallization pattern MN_2, a first through electrode TE1i1, a first lower metallization pattern DK_2, and a fourth through electrode TE4i in sequence.

In FIG. 13, a portion of the first lower metallization pattern DK_2 is covered by the first upper metallization pattern MN_1, but the first lower metallization pattern DK_2 may be connected to the first through electrode TE1i and the fourth through electrode TE4i through the lower via VL.

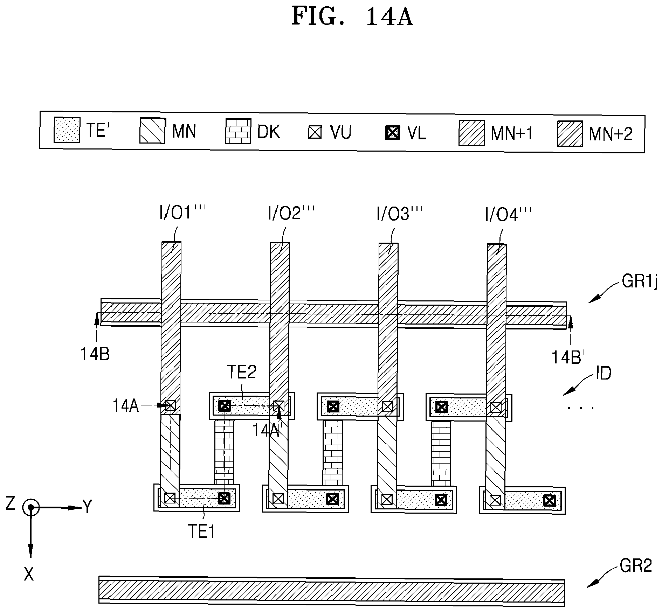

FIG. 14A a diagram for explaining a first guard ring GR1j and a plurality of input/output wires I/O1"', I/O2‴, I/O3‴, and I/O4‴ according to some other embodiments. In more detail, FIG. 14A shows a portion corresponding to FIG. 1B.

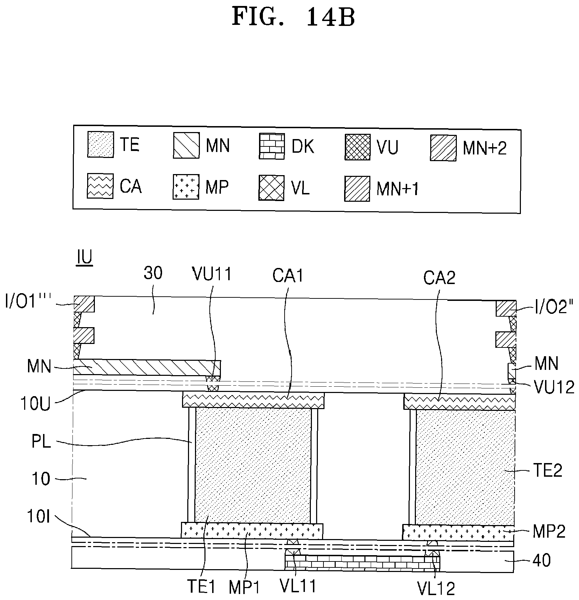

FIG. 14B is a cross-sectional view taken along cutting line 14A-14A' in FIG. 14A.

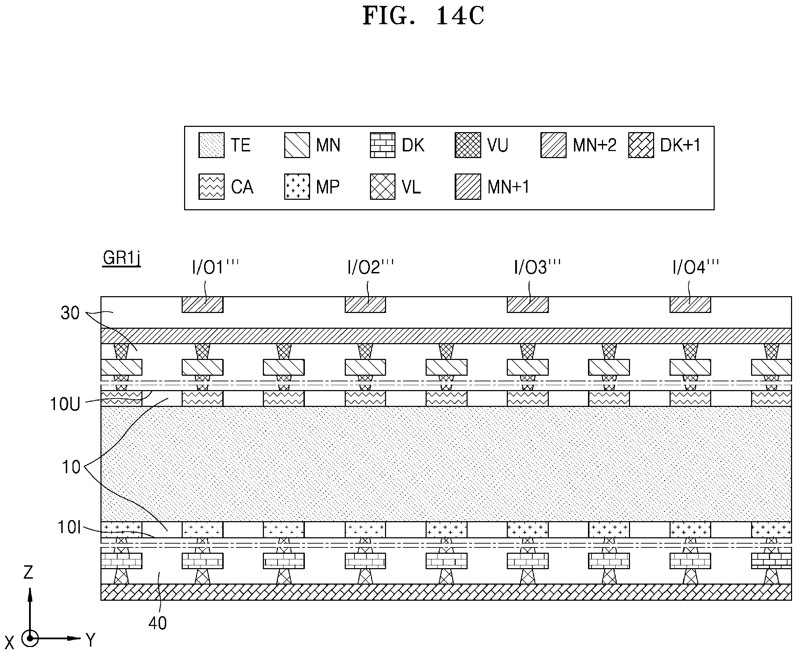

FIG. 14C is a cross-sectional view taken along cutting line 14B-14B' in FIG. 14A.

Referring to FIGS. 14A to 14C, because the inductive element ID and the second guard ring GR2 are substantially the same as those described with reference to FIGS. 1A to 2D, descriptions already given thereto are omitted.

The first guard ring GR1j may have substantially the same shape and structure as the second guard ring GR2.

According to some embodiments, the plurality of input/output wires I/O1‴, I/O2‴, I/O3‴, and I/O4‴ may include a non-inductive pattern. According to some embodiments, the plurality of input/output wires I/O1‴, I/O2‴, I/O3‴, and I/O4‴ may be farther apart from the substrate 10 than the inductive element ID. According to some embodiments, the plurality of input/output wires I/O1‴, I/O2‴, I/O3‴, and I/O4‴ may be farther apart from the substrate 10 than the first upper metallization pattern MN, which is the uppermost element included in the inductive element ID. For example, the plurality of input/output wires I/O1‴, I/O2‴, I/O3‴, and I/O4‴ may be included in the third upper metallization patterns MN+2. Island-shaped second upper metallization patterns MN+1 may be between the plurality of input/output wires I/O1‴, I/O2‴, I/O3‴, and I/O4‴ and the first upper metallization patterns MN of the inductive element ID. The second upper metallization patterns MN+1 may be pads for connection (i.e., via landing) between the plurality of input/output wires I/O1‴, I/O2‴, I/O3‴, and I/O4‴ and the first upper metallization patterns MN of the inductive element.

Each of the plurality of input/output wires I/O1‴, I/O2‴, I/O3‴, and I/O4‴ may be farther away from the substrate 10 than the second upper metallization pattern MN+1, which is the uppermost element of the first guard ring GR1j. Accordingly, each of the plurality of input/output wires I/O1‴, I/O2‴, I/O3‴, and I/O4‴ may not pass through the first guard ring GR1j. Accordingly, each of the plurality of input/output wires I/O1‴, I/O2‴, I/O3‴, and I/O4‴ may extend above the first guard ring GR1j. Each of the plurality of input/output wires I/O1‴, I/O2‴, I/O3‴, and I/O4‴ may contact a portion of the upper insulating layer 30 disposed on the first guard ring GR1j.

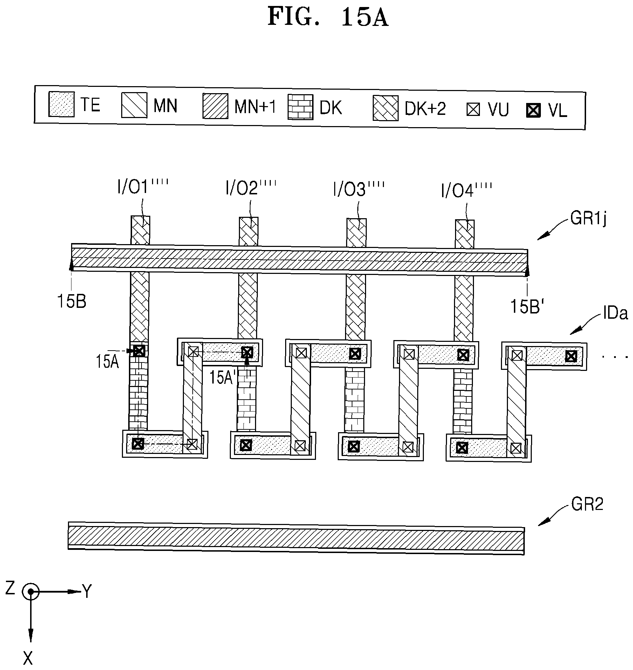

FIG. 15A is a diagram for explaining a first guard ring GR1j and a plurality of input/output wires I/O1ʺʺ, I/O2ʺʺ, I/O3ʺʺ, and I/O4"" according to some other embodiments. In more detail, FIG. 15A shows a portion corresponding to FIG. 1B.

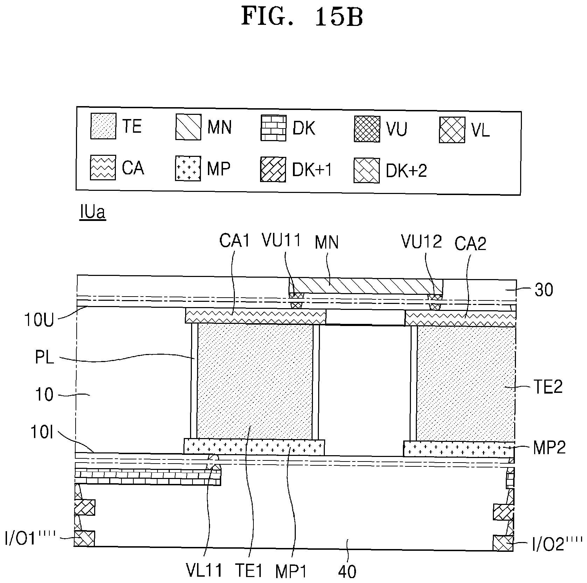

FIG. 15B is a cross-sectional view taken along the cutting line 15A-15A' in FIG. 15A.

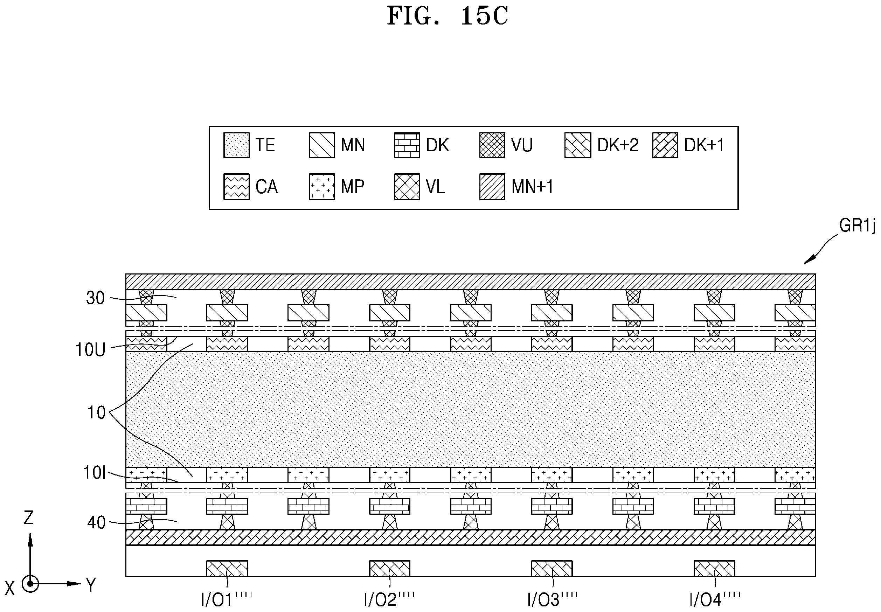

FIG. 15C is a cross-sectional view taken along cutting line 15B-15B' in FIG. 15A.

Referring to FIGS. 15A to 15C, 15A to 15C, because the inductive element IDa is substantially the same as that described with reference to FIGS. 5A to 5C and the first and second guard rings GR1j and GR2 are substantially the same as those described with reference to FIGS. 14A to 14C, descriptions already given thereto are omitted.

According to some embodiments, the plurality of input/output wires I/O1"", I/O2"", I/O3"", and I/O4"" may include a non-inductive pattern. According to some embodiments, the plurality of input/output wires I/O1"", I/O2"", I/O3"", and I/O4"" may be farther apart from the substrate 10 than the inductive element ID. According to some embodiments, the plurality of input/output wires (I/O1ʺʺ, I/O2ʺʺ, I/O3"", and I/O4"" may be farther apart from the substrate 10 than the first lower metallization pattern DK, which is the lowest element included in the inductive element ID. For example, the plurality of input/output wires I/O1"", I/O2ʺʺ, I/O3ʺʺ, and I/O4"" may be included in the third lower metallization patterns DK+2. Island-shaped second lower metallization patterns DK+1 may be between the plurality of input/output wires I/O1ʺʺ, I/O2"", I/O3"", and I/O4"" and the first lower metallization patterns DK of the inductive element ID. The second lower metallization patterns DK+1 may be pads for connection (i.e., via landing) between the plurality of input/output wires I/O 1"", I/O2"", I/O3"", and I/O4"" and the first lower metallization patterns DK of the inductive element.

Each of the plurality of input/output wires I/O1"", I/O2ʺʺ, I/O3"", and I/O4"" may be farther away from the substrate 10 than the second lower metallization pattern DK+1, which is the lowermost element of the first guard ring GR1j. Accordingly, each of the plurality of input/output wires I/O 1"", I/O2"", I/O3"", and I/O4"" may not pass through the first guard ring GR1j. Accordingly, each of the plurality of input/output wires I/O1"", I/O2"", I/O3"", and I/O4"" may extend below the first guard ring GR1j. Each of the plurality of input/output wires I/O1"", I/O2"", I/O3"", and I/O4"" may contact a portion of the lower insulating layer 40 disposed under the first guard ring GR1j.

According to some embodiments, an inductive element (e.g., the inductive element ID in FIG. 1B) may include a plurality of unit inductors. Each of the plurality of unit inductors may include a number 2 × N of a plurality of through electrodes that are in or extend through a substrate (e.g., the substrate 10 in FIG. 2B). N is an integer greater than or equal to 1, and N is the number of turns in each of the plurality of unit inductors.

## Claims

1. An integrated circuit comprising:
a substrate including an active region on which a plurality of transistors constituting a logic circuit are provided;
an inductive element adjacent to the active region and extending along an edge of the active region; and
first and second guard rings configured to shield the active region from magnetic flux generated from the inductive element,
wherein the inductive element comprises:
a first through electrode extending in a first direction that is perpendicular to an upper surface of the substrate;
an upper metallization pattern connected to the first through electrode and extending in a second direction that is perpendicular to the first direction; and
a lower metallization pattern connected to the first through electrode and extending in the second direction,
wherein the upper metallization pattern and the lower metallization pattern are spaced apart from each other with the first through electrode therebetween.

2. The integrated circuit of claim 1, wherein the inductive element further comprises a second through electrode connected to the lower metallization pattern and spaced apart from the first through electrode.

3. The integrated circuit of claim 2, wherein a portion of the substrate is between the first through electrode and the second through electrode.

4. The integrated circuit of claim 2 or 3, further comprising a first permeability control layer between the first through electrode and the second through electrode and having a permeability that is different from that of the substrate.

5. The integrated circuit of claim 4, wherein the first permeability control layer is between the substrate and the upper metallization pattern.

6. The integrated circuit of claim 4 or 5, further comprising a second permeability control layer on the first permeability control layer and between the first and second through electrodes and having a permeability different from that of the substrate.

7. The integrated circuit of any one of the preceding claims,
wherein the upper metallization pattern, the lower metallization pattern, and the first through electrode of the inductive element constitute a wound structure, and
a winding axis of the inductive element is parallel to a third direction that is perpendicular to each of the first and second directions.

8. An integrated circuit comprising:
a first guard ring;
a second guard ring spaced apart from the first guard ring; and
an inductive element between the first guard ring and the second guard ring,
wherein the inductive element comprises:
a first through electrode in a substrate;
a first upper metallization pattern connected to the first through electrode and on an upper surface of the substrate;
a first lower metallization pattern connected to the first through electrode and on a lower surface of the substrate opposite to the upper surface of the substrate; and
a second through electrode connected to the first lower metallization pattern, in the substrate, and spaced apart from the first through electrode,
wherein the first upper metallization pattern, the first through electrode, the first lower metallization pattern, and the second through electrode constitute a wound structure having a winding axis extending in a first direction that is parallel to the upper surface of the substrate.

9. The integrated circuit of claim 8, wherein the inductive element includes a structure wound multiple times on a cross-section perpendicular to the first direction.

10. The integrated circuit of claim 8 or 9,
wherein the inductive element further comprises:
a second upper metallization pattern connected to the second through electrode and on the upper surface of the substrate;
a third through electrode connected to the second upper metallization pattern and in the substrate;
a second lower metallization pattern connected to the third through electrode and on the lower surface of the substrate;
a fourth through electrode connected to the second lower metallization pattern and in the substrate; and
a third upper metallization pattern connected to the fourth through electrode and on the upper surface of the substrate.

11. The integrated circuit of claim 10,
wherein the first, second, third and fourth through electrodes overlap each other in a second direction, and
the second direction is parallel to the upper surface of the substrate and perpendicular to the first direction.

12. An integrated circuit comprising:
an inductive element extending along an edge of an active region including a plurality of transistors;
a first guard ring between the active region and the inductive element; and
a second guard ring spaced apart from the first guard ring with the inductive element therebetween,
wherein a winding axis of the inductive element extends in a first direction that is parallel to an upper surface of a substrate, and
the inductive element includes a plurality of through electrodes that extend in a second direction perpendicular to the upper surface of the substrate and are in the substrate.

13. The integrated circuit of claim 12, wherein the inductive element includes a plurality of unit inductors arranged in the second direction.

14. The integrated circuit of claim 13, wherein each of the plurality of unit inductors includes a structure wound multiple times on a cross-section perpendicular to the first direction.

15. The integrated circuit of claim 13,
wherein each of the plurality of unit inductors comprises:
upper metallization patterns on the upper surface of the substrate and connected to at least one of the plurality of through electrodes; and
lower metallization patterns on a lower surface of the substrate opposite to the upper surface thereof and connected to at least one of the plurality of through electrodes,
wherein the upper metallization patterns and the lower metallization patterns are spaced apart from each other with the plurality of through electrodes therebetween.
